(19) Europäisches Patentamt
European Patent Office
Office européen des brevets

(11) EP 2 784 191 A1

(12) # EUROPEAN PATENT APPLICATION

(43) Date of publication:
**01.10.2014 Bulletin 2014/40**

(21) Application number: **14159915.9**

(22) Date of filing: **14.03.2014**

(51) Int Cl.:
***C30B 25/08*** *(2006.01)* ***C30B 23/00*** *(2006.01)*
***C30B 23/06*** *(2006.01)*

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **15.03.2013 US 201313844182**

(71) Applicant: **Nitride Solutions Inc.**
**Wichita, Kansas 67213 (US)**

(72) Inventors:
- **Schmitt, Jason**
  **Wichita, KS 67213 (US)**
- **Lu, Peng**
  **Wichita, KS 67213 (US)**

(74) Representative: **Bumke, Jakob Wenzel et al**
**Greaves Brewster LLP**
**Copa House**
**Station Road**
**Cheddar BS27 3AH (GB)**

(54) **Low carbon group-III nitride crystals**

(57) The present disclosure generally relates to systems and methods for producing and using Group-III nitride crystals that have enhanced or increase ultraviolet transparency in a range of wavelengths. The crystals may also be used in a number of UV optics and UV optical semiconductor devices.

EP 2 784 191 A1

## Description

### FIELD OF THE PRESENT DISCLOSURE

The present disclosure relates to systems and methods for producing Group-III Nitride crystals, semiconductors, and other compositions or devices that have ultraviolet transparency properties suitable for use in ultraviolet optics and ultraviolet optical semiconductor devices. The disclosure also relates to the crystals, semiconductors, and other compositions or devices containing the crystals.

### BACKGROUND OF THE PRESENT DISCLOSURE

Group-III Nitride or III-Nitride crystals, especially those having higher Al content, are desirable for use in ultraviolet (UV) optics and UV optical semiconductor devices due to their inherent UV transparency in the range from 400 nm to below 210 nm. Currently, however, optical absorption for Group-III Nitride crystals in the mid and deep UV region is not suitable for the development of practical UV optics and UV optical semiconductor devices having optical absorption in the 70-90% range for wavelengths below 300 nm. Most group-III nitride crystals have a sharp drop off of for UV transparency before their theoretical cut-off wavelength. This is especially true for AlGaN and AlN III-Nitride crystals having a high content of Al. The increased optical absorption has previously been attributed to oxygen concentration in the crystal. However, efforts to reduce only the concentration of oxygen alone have not provided sufficiently improved UV transparency in Group-III Nitride crystals below 300 nm. Other efforts to decrease UV absorption have included decreasing the thickness of the crystal; however, these have been met with limited success.

Typically, high temperatures are required to produce quality III-Nitride crystals, especially those with higher Al content. Two methods usually used to produce the crystals are hydride vapor phase epitaxy (HVPE) and physical vapor transport (PVT). High temperatures and good production rates may be difficult to achieve using the HVPE processes. Most HVPE reactors use a quartz wall and transport tube/flow channels system. Quartz-based high temperature HVPE reactors suffer from many problems that may limit the maximum temperature, such as the high temperature reaction of quartz with and hydrogen chloride (HCl). The problems associated with quartz in the presence of HCl is well known and documented in U.S. Patent 4,808,551 to Mori et al., which is herein incorporated in its entirety by reference.

The reaction of quartz with metal halides is also problematic. This is evident for halide-based AlN growth when an aluminum monohalide, such as AlCl, AlI or AlBr) is formed. For metal halides, in particular a chloride - Si interaction at elevated temperatures makes the growth of AlN problematic. For example, structural deterioration of the reactor occurs, as the quartz-based reactor is attacked by both precursor and post-reaction gases, such as $MCl_x$ and HCl. Each of the species attacks the Si in the quartz and can cause catastrophic failure of the system during prolonged exposure.

In addition, quartz in the presence of metal halides may cause the unwanted incorporation of Si into the produced crystal. For example, $SiCl_x$ produced in the quartz reactor enters the III-nitride reaction gas mix, where Si acts like an N-type dopant in the III-nitride semiconductor system. Additionally, Si has been identified as an agent that reduces UV transparency in III-nitride optoelectronic devices when introduced at high temperatures.

Another attempt to improve UV transparency is disclosed in U.S. Patent Application Publication No. US 2008/0083970, which is herein incorporated in its entirety by reference. This attempt proposes the use of exotic refractory metal carbides and nitrides. At elevated temperatures, however, these materials can outgas the base refractory metal and/or carbon. In addition, the material may also outgas boron. Boron has been shown to affect the growth kinetics of AlN, while carbon introduced in AlN at high temperatures is shown as an impurity that reduces UV transparency in III-nitride optoelectronic devices. Furthermore, the refractory metal coatings disclosed in this publication have a tendency to pit and sprawl, which exposes the underlying materials.

Therefore, a need exists for systems and methods to eliminate unwanted Si, C, and B impurities at elevated temperatures (e.g. above 1200° C).

### SUMMARY OF THE PRESENT DISCLOSURE

The present disclosure relates to Group-III Nitride ("III-nitride") crystals having low carbon and/or silicon concentrations. In various embodiments, the crystals have a concentration of carbon and or silicon below approximately $2\times10^{18}$ atoms/cm$^3$. In addition, the crystals have improved and sufficient ultraviolet (UV) transparency for use in UV electronic devices, among others, the methods of production, apparatus used in production and intended use in the semiconductor industry is disclosed herein.

The III-nitride crystal of the present disclosure may be defined as a single crystal of form $In_{(w)}Al_{(x)}Ga_{(y)}C_{(a)}Si_{(b)}N_{(z)}$ where $1\text{-}x\text{-}w \neq y$, $w\text{-}z\text{-}y\neq0$, $w+x+y\text{-}z\neq0$, $(2\geq w\geq0)$, $(2\geq x\geq0)$, $(2\geq y\geq0)$, $(2\geq z\geq0)$, and the concentration of either C, and/or Si is below $2\times10^{18}$ atoms/cm$^3$. The total concentration of other species in the III-nitride crystal may be greater than $1\times10^{17}$ as long as such species do not interfere with the UV optical transparency. In various embodiments, the crystal is non-stoichiometric.

The III-nitride crystal can be produced using physical vapor transport (PVT), chemical vapor deposition or solvothermal methods, such as sublimation, hydride vapor phase epitaxy (HVPE) and ammonothermal transport. PVT, HVPE and ammonothermal transport are preferred methods for producing the crystal and devices disclosed herein.

In various embodiments, III-Nitride crystals were prepared using various methods to eliminate carbon and/or silicon sources. These and other features, aspects, and advantages of the present disclosure will become better understood with reference to the following descriptions and claims.

## DESCRIPTION OF FIGURES

FIG. 1 is a graph showing the UV transmission of low carbon AIN using "carbon free" PVT vs. stander PVT according to one embodiment.

FIG. 2 is a graph showing the UV transmission of low carbon AIN using "carbon free" HVPE according to one embodiment.

FIG. 3 is a cross-sectional view of a reactor for the production of low carbon AIN by "carbon free" PVT according to one embodiment.

FIG. 4 is a cross-sectional view of a reactor for the production of low carbon AIN by "carbon free" HVPE in a horizontal configuration according to one embodiment according to one embodiment.

FIG. 5 is an illustration of one embodiment of the carbon free polycrystalline AIN coating on a preformed tube according to one embodiment.

FIG. 6 is a cross-sectional view of a reactor for the production of low carbon AIN by polycrystalline AIN coating of carbon based HVPE part in a horizontal configuration.

FIG. 7 depicts a polycrystalline AIN coating encasing a preformed boat.

FIG. 8 depicts a polycrystalline AIN internal HVPE reactor component body made by using a coated carbon body as a support material according to one embodiment.

FIG. 9A is a cross-sectional view of a reactor for the production of low carbon AIN by "carbon free" HVPE in a vertical configuration according to one embodiment.

FIG. 9B is top down view of a single crystal boat 901 position within flow tubes of the reactor of FIG. 9A, according to one embodiment.

FIG. 10 is an illustration of an AIN III-Nitride crystal attached seed according to one embodiment.

FIG. 11 is an illustration of III-Nitride crystal removal from a seed to produce a free standing crystal according to one embodiment.

FIG. 12 depicts a freestanding large grain Polycrystalline AIN body 2.5" in diameter for use as an internal component in an HVPE reactor according to one embodiment.

FIG. 13 depicts a large grain Polycrystalline AIN body 6" by 6" over 5 mm thick reinforced by a backing material for use as an internal component in an HVPE reactor according to one embodiment.

FIG. 14 depicts a freestanding large grain Polycrystalline AIN body 4.5" in diameter reinforced by a preformed reinforcing support material for use as an internal component in an HVPE reactor according to one embodiment.

FIG. 15 depicts a boat liner used to hold metal for the reaction of metal into metal halides in an HVPE reactor according to one embodiment.

FIG. 16 depicts a showerhead used to introduce gaseous source material into a vapor deposition reactor according to one embodiment.

FIG. 17 depicts an AIN crystal made by a PVT method according to one embodiment.

FIG. 18 is a flowchart depicting a method of preparing an III-Nitride substrate according to one embodiment.

FIG. 19 is a flowchart depicting a method of preparing an III-Nitride substrate according to one embodiment.

## DETAILED DESCRIPTION

The present disclosure relates to systems and methods for high temperature Aluminum nitride (AIN) growth using hydride vapor phase epitaxy (HVPE). In various aspects, the components of a reactor, including but not limited to a reaction tube or vessel, flow channels, and gas inlets, are preferably made of materials suitable for high temperature. The selection of these materials may impact the resulting purity and quality of crystals grown therein.

Carbon (C) and/or silicon (Si), when introduced at high temperatures, have been noted for reducing the ultraviolet (UV) transparency in Group-III Nitride ("III-Nitride") optoelectronic devices. The unintended incorporation of Si and C into grown III-Nitride crystals can have undesired effects on the UV transparency of the crystals. While, Si can be useful dopant III-nitride semiconductor systems, it is preferably introduced in a controllable manner at low temperatures. As

AlN, AlGaN, and alloys thereof, are desired materials for producing UV optoelectronic devices and systems, it is desirable to decrease the content of C, Si, and even boron (B) in such crystals.

Figure 1 shows the optical absorption for AlN III-Nitride crystal substrate (dashed line) with a volume larger then $700^{-5}$ $mm^3$ where the optical absorption drops to near 100% at around 280 nm. This is before the 200-210 theoretical limited drop off for AlN

In various embodiments, the III-nitride crystal can be produced using physical vapor transport (PVT), chemical vapor deposition, or solvothermal methods, such as sublimation, hydride vapor phase epitaxy (HVPE) and ammonothermal transport. PVT, HVPE, and ammonothermal are preferred methods of production and here in disclosed.

As previously discussed, quartz- based reactors are often used to grow III-nitride crystals. However, in addition to the reactivity of quartz with HCl and metal halides at high temperatures, the quartz itself cannot withstand heating beyond 1250° C; the maximum reported working temperature for quartz. Moreover, many reactors used for HVPE, use external heaters that limit the maximum temperature to below the melting point of quartz. Some crystal growth has been sustained at elevated temperatures using a localized heat source to increase the temperature at the substrate surface. However, a localized heat source causes undesirable uniformities during HVPE growth. In addition, a localized heat source may produce turbulence in the reaction zone due to the difference in the temperatures of the cooler precursor gasses and the heated substrate holder. Moreover, using a localized heat source is undesirable in the bulk growth of HVPE crystals. Localized heating only heats the back of the growth surface. This may cause a temperature gradient between the front growth surface and the backside of the growing crystal boule. As the boule grows, the temperature at the crystal growth surface will decrease. This may introduce stress into the crystal similar to that observed in PVT and ultimately destroy the crystal quality.

Conversely, the use of a hot-walled system, where all the internal parts of the reactor will be at nearly the same temperature will reduce recirculation flows generated by natural convection. In a true hot wall reactor, the thermal gradients are small and thus the precursors are efficiently heated. As such, the present disclosure also relates to reactors and reactor components that may be used to produce III-nitride crystals having low C, SI, and/or B content.

There is a desire to produce UV transparent III-Nitride crystals that offer improved transparency beyond the 300 nm wavelength. Both in optics and semiconductor optoelectronics, the presence of carbon, and to a lesser extent Si, in III-nitride crystals with increasing Al content pose a fundamental previously unknown roadblock to the production of UV transparent III-Nitride crystals. At the high temperatures needed to produce III-Nitride crystals, both carbon and silicon can readily be unintentionally incorporated into the III-Nitride crystals. Depending on the temperature, the effect of the incorporated carbon (C) and Si can be a p-type dopant with little-to-no effect on the UV transmission as is the case for the lower temperatures of metalorganic chemical vapor deposition (MOCVD) and molecular beam epitaxy (MBE) growth. These impurities can cause a strong reduction in the whole transmission spectrum in the case of mid-temperature growth and may cause a full cut off around 300 nm for high-temperature AlN growth. This may be attributed to the thermal energy given to the C or Si atom and its ability to sit on thermodynamically preferred sites in/on the lattice and cause carbon and silicon complexes. The formation energies of the complexes formed by C or Si are strongly dependent on the Fermi level position and III/N ratio in the low-to-mid temperature range. Growth under III or N rich regimes leads to different energy of formation for C and Si. Under N-rich conditions, for instance, there can be self-compensation of $C_N$ acceptors by $C_{III}$ donors. The energetically favored type of complexes caused by the carbon and/or silicon depends heavily on the growth conditions and is in practical terms impossible to control for higher-temperature production methods such as HVPE and PVT. Thus, it is understood that the carbon and/or silicon can be located in any position with in the crystal, on sites such as substitutional carbon and/or silicon on the group III aluminum, gallium or indium site or on the group V nitrogen site, form clusters, or occupy an interstitial site. Furthermore, carbon and/or silicon can have a secondary effect, causing group III aluminum, gallium or indium and/or group V nitrogen vacancy, antisite substitution, and Frenkel complexes. As such, the carbon and/or silicon can act as stated above as an acceptor or donor in a shallow or deep energy level, severely affecting the optical and electrical properties of the III-Nitride crystal system depending on the growth temperature and growth conditions. The introduction of carbon into the Al rich III-Nitride system does not appear to have a negative affect on the crystal quality when incorporated at temperatures above 2000° C, as is the case for AlN PVT growth. This holds true for even large amounts of carbon and/or silicon in excess of $2\times10^{18}$ atoms/$cm^3$. Levels that turn the AlN crystal green-blue due to bandgap absorption still show good crystalline quality. This could be due to the affinity of AlN to alloy with SiC to produce AlSiCN.

The systematic reduction of carbon and/or silicon in III-Nitride crystals can lead to having a sufficiently improved UV transparent for use in UV optics and semiconductor devices such as UV light-emitting diodes and laser-diodes by eliminating these complexes. Therefore, a method of growing crystals that allows for precise control over carbon and/or silicon incorporation is desired, and is one of the features of the reactors, systems, and methods disclosed herein.

In various embodiments, III-Nitride crystals were prepared using various to eliminate carbon and/or silicon sources. In one embodiment, a method to produce III-nitride crystals and preferably high Al-content AlN, AlGaN, and InAlN crystals via high temperature HVPE is described below. This method facilitates reduced carbon and/or silicon incorporation into the III-Nitride crystals. In one aspect, the growth temperatures at the crystal growth surface reach around 2450° C and are no less then 1175° C.

In this method, the internal reactor walls in contact with the HVPE reaction gases (Reaction tube inner surfaces) are heated via susceptor induction or resistive heat external to the reactor reaction tubes inner surface. III-Nitride crystals are deposited on either foreign material, AIN substrate with defects less then $1x10^7$ or are freely nucleated in the reactors volume

The AIN internal components can be made from sintered AIN, PVT AIN and CVD AIN as freestanding components or as sintered AIN, PVT AIN and CVD AIN that use a preformed reinforcing support as long as the coating is suitably thick or is not a superficial coating. Furthermore, the AIN can be a mixture of AIN and filler. The filler can be a metal or any other suitable material.

In standard HVPE systems, three zones are used. The first zone is the source zone where the precursor material is held at an elevated temperature to facilitate the metal-halide reaction. In standard HVPE systems, depending on the metal-halide used, temperatures in the source zone are between 400-600° C. In high temperature HVPE, source temperatures range from 700° C-1500° C. This requires internal components capable of withstanding temperatures in excess of 1500° C. To keep the gas phase impurities down, internal components should preferably decompose in to constituent species of the gas phase and may contain minimal carbon; however preferably should not contain any carbon. This is illustrated with the growth of AIN in an AIN coated boat where, at elevated temperatures, the HCl will decompose the AIN coated boat to give AlCl, as given by:

$$2HCl + 2AlN \rightarrow N2 + H2 + 2AlCl. \qquad \text{Eq. 1}$$

High temperatures can also sublimate the AIN, as given by:

$$AlN \rightarrow Al + 1/2N \qquad \text{Eq. 2}$$

Wherein the AlCl, N2, Al(g) and 1/2N are components of the gas source species used to produce AIN in the HVPE method given by the equations below:

$$2HCl(g) + Al(l) \rightarrow AlCl(g) + H2 \qquad \text{Eq. 3}$$

$$AlCl(g) + NH3 \rightarrow AlN(s) + HCl(g) \qquad \text{Eq. 4}$$

OR

$$3AlCl(g) + N2 \rightarrow 2AlN(s) + AlCl3(g) \qquad \text{Eq. 5}$$

One skilled in the art would understand the internal components of the source zone to be the metal source boat 401, boat liners 1502,1503, outlet tubes 417, flow channels 407, showerheads 16 and reaction tube 421 or any other internal structure inside the reactor housing, as shown in FIGS 4, 15, and 16 .

The showerhead 16 includes inlet assemblies that connect the inlet gas lines to the showerhead. The showerhead includes a gas dispersion feature on the downstream face of the showerhead that optimizes the flow of gaseous material into the reaction chamber and on to the III-Nitride growth surface. The showerhead can be heated by induction or any other suitable heating method to increases the temperature of the gaseous material.

The second zone is the mixing zone where the precursor gases mix. This can take place in many configurations. The simplest is for the gases to exit outlet tubes 417, flow channels or a showerhead and mix in the open volume 1608, 499, 699,999 of the reactor tube or in a dump tube. In standard HVPE systems, depending on the metal-halide used, temperatures in the mixing zone can be as low as 400° C . In high temperature HVPE mixing temperatures range from 1250° C-1900° C. This requires internal components capable of withstanding temperatures in excess of 1250° C and in the extreme case internal components capable of withstanding temperatures in excess of 1900° C.

Superficial AlN and other nitride, carbide, oxide, and pBN coatings do not tend to have a working temperature over 1300° C when used in used in PVT or HVPE environments. This is in part due to the superficial coating's thermal expansion coefficient mismatch with the reinforcing/backing material's and in part due to the extremely corrosive nature of the III-Nitride crystal species, Al, Ga, HCl, AlCl, and other process gases when used to produce III-Nitride crystals above 1300° C. The thermal expansion coefficient differences cause coated parts to crack and spall during heating and thermal cycling, exposing the underlining reinforcing/backing material. The small grain and amorphous nature of both superficial coating and current in-situ coating only increases this cracking and spalling problem and increases the coating susceptibility to attack. To keep the gas phase impurities down, internal components should preferably decompose into gas phase constituent species of the III-Nitride crystal as shown in Eqs. 2-5. It is desired that the internal components and/or coatings do not contain free carbon, and preferably do not contain any carbon. In addition, it is desired that the components are able to withstand the thermal cycling without exposing the underlining reinforcing/backing material. Thus for the above-mentioned reasons, a thick polycrystalline coating is required. Yet any material that ensures low carbon species introduction into the gas phase during growth is acceptable. Thick polycrystalline AlN meets all these requirements. Where the coating is at least 10 microns thick and preferably above 100 microns thick. A perfect embodiment would be a freestanding polycrystalline AlN body with grains larger then 0.1 mm. Such a coating resulting in both freestanding bodies and bodies reinforced by a backing material has been produced by the authors for the purpose of producing internal components in III-Nitride crystal production by HVPE and PVT and are shown in Figures 12, 13 and 14.

One skilled in the art would understand the internal components of the mixing zone to be the metal source boat, boat liner, inlet tubes, outlet tubes, flow channels, showerhead and reaction tube or any other internal structure inside the reactor housing.

A method to produce said III-Nitride crystals (preferably high Al content AlN, AlGaN where the Al is above 25 atomic %) via a novel high temperature PVT method that enables reduced carbon and/or silicon incorporation into the III-nitride crystal is described below. The PVT or PVT fabrication of large III-nitride crystals with low induced carbon, low internal stress, and of high crystalline quality has proven quite difficult. Material problems have been identified as being a major obstacle in growth of high-purity, large-size AlN crystals. In AlN growth by PVT, temperatures in excess of 2200° C are required to achieve commercially viable growth rates. At these temperatures, Al vapor is highly reactive with all but the most robust materials. Graphite and SiOx foam are commonly used as insulation to achieve these high temperatures; not only does graphite introduce carbon into the system, but silicon from the impurities in the graphite. A lack of large III-Nitride crystals seeds lends to the use of thermal grain expansion by using bowed thermal fields, again achieved in part with graphite and SiO foam insulation. The bowed thermal fields used to expand the AlN seed crystal to produce bulk AlN induce stress into the crystals. This stress is transferred throughout the bulk of the produced AlN. This is done at the cost of introducing carbon and/or silicon into the crystal structure. Large area SiC seeds, up to 4" in diameter, have been used and rendered disappointing results. AlN growth on SiC led to highly ordered polycrystalline material where large grains are orientated in the z-axis perpendicular to the SiC surface, but are tilted or at low angle mismatch in the x-y plane. Again, both Si and carbon are introduced into the crystal from the direct solid diffusion from the SiC substrate through the AlN and from the vapor phase as the SiC sublimes underneath the AlN. SiC starts to sublime into silicon and carbon at temperatures far below the optimal AlN production temperature. In various embodiments, the internal components of standard PVT and HVPE reactor are replaced with low-vapor pressure or carbon and/or silicon free components to produce increased UV transparent crystals with volumes larger then 0.2-5 $mm^3$.

PVT manufacturing of low carbon AlN (Embodiment 1)

As shown in FIG. 3, a reactor used manufacture low carbon AlN III-Nitride crystal using PVT is shown. An AlN source 301 is loaded in a carbon-free hollow crucible 303 of a high temperature induction reactor 309 that is suitably C free. The source may come in any of a number of forms and/or thicknesses, including but not limited to from 0.1 micron powder to 10 mm polycrystalline AlN. The crucible 303 may rang in size from 1" to over 30" in diameter. The packed crucible with the AlN body is placed in the high temperature induction reactor 303. The crucible is heated by a carbon-free susceptor 305 inside a radio frequency (RF) induction field provided by the RF induction coil 307. Multiple layers of carbon-free insulation on the top 309 and bottom 311 control the internal thermal fields along with the carbon-free susceptor 399 placement the induction coil 307 placement, length, and the induction coils-to-coil gaping. The high-temperature induction reactor is vacuumed to below 1x10-2 torr and backfilled/purged with nitrogen before pulling another vacuum below 1x10-2 torr. The crucible is heated under vacuum to about 1700° C for about 0.5-20 hours, with 5 hours being preferred to drive off native carbides, and silicon compounds in the AlN body. The temperature of the crucible is then increased to 2000-2450° C in one hour and allowed to soak at 2000-2450° C for up to 200 hour. A gradient driving force using temperature and chemical concentration is established between the higher end of the gradient, higher temperature higher chemical concentration inside the crucible 399 across the AlN body 301 such that the AlN body disassociates into Al and N species 313 and driven to re-crystallize producing a AlN crystal 315 at a lower temperature and chemical concentration inside the crucible. The thermal and chemical driving force is controlled by: internal thermal fields, established by the multiple layers of carbon-free insulation 309, 311 on the top and bottom, carbon-free susceptor 305 placement, induction coil 303 placement, induction coil length, coil-to-coil gaping, AIN body 301 size, and the AIN body thickness. Alternatively, the top and/or the bottom of the crucible can be closed by carbon-free top 317 and bottom 319 lids held at a lower temperature than the AIN body to capture many of the native carbides and silicon compounds that are driven off from the AIN body. The lids can be replaced prior to increasing the temperature by cooling the reactor down and removing the crucible 303 to remove the captured native carbides and silicon compounds that are driven off from the AIN body. The crucible is then placed once again into the high temperature induction reactor and said steps above are repeated.

The resulting crystal 315, shown in FIG 17 can range from a single a low carbon re-crystallize AIN crystal with a diameter larger then 1 $mm^2$ and a volume larger them 0.3 $mm^3$ to multiple low carbon freely nucleated re-crystallize AIN crystals with a diameter larger then 1 $mm^2$ and a volume larger them 0.3 $mm^3$.

At this time, the AIN body can be recharged with AIN to increase the size of the AIN crystal by repeating the process. Additional AIN of varying size from 0.1 microns to 10 mm is loaded inside the carbon-free crucible. The crucible is then placed once again into the high temperature induction reactor and said steps above are repeated. The recharge and growth cycles can be repeated to increases crystal size as desired.

<u>HVPE manufacturing of low carbon AlGAN without using carbon (Embodiment 2)</u>

This example shows how to manufacture low carbon and low silicon AlGaN III-Nitride crystal using a novel high temperature HVPE method. Figure 4 is a cross-section view of one embodiment of a HVPE reactor 40 configured for producing low carbon and low silicon AlGaN III-Nitride crystals, where the reactor is mounted in a horizontal configuration.

In one example, Fifty grams of aluminum and fifty grams of gallium metal in any form are placed in separate polycrystalline AIN coated single crystal sapphire boats 401, 403 capable of handling temperatures in excess of 1500° C, The aluminum and gallium filled boats are loaded into two different polycrystalline AIN coated niobium flow channels 405 407 inside a Al2O3 process tube 409 coated with polycrystalline AIN.

The intended surface for the production of the III-Nitride crystal 411 is preferably a single crystal substrate or seed mounted on a polycrystalline AIN coated Al2O3 pedestal or platter 413, at an inclined orientation. The HVPE reactor is vacuumed to below 1x10-2 torr and backfilled/purged with nitrogen before pulling another vacuum below 1x10-2 torr. The reactor is returned to a pressure between 1 torr and 5000 torr under a nitrogen environment where 760 torr is preferred. The source zone is heated to 1000C and the growth zone is heated to 1300° C. Reactant gases 415, 417,419 421 are flowed into the reactor. Reactant gases flow for all gases range from 0.01 SLM to 100 SLM, where a flow rate under one SLM is preferred. In this embodiment, the reactant gas 421 is ammonia separated from the other gases in the source zone 41 by a polycrystalline AIN coated Al2O3 flow channel 423. The carbon free polycrystalline AIN coating 501 keeps the free HCL from attacking the boat and flow channels shown in FIG 5 allowing a carbon free material 503 to be used such as preformed single crystal sapphire and refractor metals instead of carbon based uncoated carbon structures. Carbon structure is define as a carbon based article that can be of any suitable shape size or volume in any form or physical density used for producing an internal component in part or in whole of a HVPE reaction. This includes Metal Matrix Composites and Ceramic Matrix Composites structure that are in part carbon based. Reactant gas 417 and 419 are HCl. The HCL is chemically reacted with the fifty grams of aluminum and fifty grams of gallium metal to form metal-chloride. Reactant gas 415 is a carrier gas to facilitate flow. The metal-chlorides are reacted with the ammonia at the III-Nitride crystal surface 411 to form AlGaN. Reactant gas 415 in this embodiment may be nitrogen, argon, hydrogen, or any inert gas. The reactant gases and their gaseous byproducts are removed from the reactor via the exhaust 417.

The HVPE reactor is heated by an induction coil 419 that is inductively coupled to a susceptor 431, which may be graphite if the susceptor is not also the reaction tube. The reaction tube 409 is a tube inside the susceptor that is at least as long as the susceptor and prevents exposure of everything inside the inner diameter of the reaction tube from the susceptor. If the susceptor and reaction tube are the same piece of material, it is preferably a non-graphite tube; however, if a sufficiently thick [For example] polycrystalline AIN coating is used, the susceptor can be made in-part or entirely of graphite. The susceptor is surrounded by thermal insulation 423 to limit heat loss.

<u>HVPE manufacturing of low carbon AlGAN using carbon (Embodiment 3)</u>

This example shows how to manufacture low carbon and low silicon AlGaN III-Nitride crystal using a novel high temperature HVPE method. Figure 6 is a cross-sectional view of one embodiment. The figure shows a HVPE reactor for low carbon and low silicon AlGaN III-Nitride crystal production, where the reactor is mounted in a horizontal configuration.

Fifty grams of aluminum and fifty grams of gallium metal are placed in separate polycrystalline AIN coated 701 carbon boats 601, 603,70 shown in detail in FIG 7 capable of handling temperatures in excess of 1500° C, The aluminum and gallium filled boats are loaded into two different polycrystalline AIN coated carbon flow channels 605, 607 inside the polycrystalline AIN coated Al2O3 process tube 609 of a HVPE reactor.

The intended surface for the production of the III-Nitride crystal 611 is preferably a single crystal substrate or seed mounted on a polycrystalline AIN coated Al2O3 pedestal or platter 613 at an inclined orientation. The HVPE reactor is vacuumed to below 1x10-2 torr and backfilled/purged with nitrogen before pulling another vacuum below 1x10-2 torr. The reactor is returned to a pressure between 1 torr and 5000 torr under a nitrogen environment where 200 torr is preferred. The source zone 61 is heated to 1000° C and the growth zone is heated to 1300° C. Reactant gases 615, 617,619 621 are flowed into the reactor. In this embodiment, the reactant gas 621 is ammonia separated from the other gases in the source zone by a polycrystalline AIN coated Al2O3 flow channel 623. Reactant gas 617 and 619 are HCl. The HCl reacts with the fifty grams of aluminum and fifty grams of gallium metal in the polycrystalline AIN coated carbon boat 70 to form metal-chloride. The polycrystalline AIN 701 coating keeps the free HCl from attacking the carbon boat 703 and flow channels; thus, aluminum and gallium metal halides are formed without carbon contamination. Polycrystalline AIN of sufficient thickness can be used with a multiple layer coating structure to enhance the ability of AIN to block carbon outgassing from the carbon based carbon structures. Carbon structure is define as a carbon based article that can be of any suitable shape size or volume in any form or physical density used for producing an internal component in part or in whole of a HVPE reaction. This includes Metal Matrix Composites and Ceramic Matrix Composites structure that are in part carbon based

Fig. 8 shows a polycrystalline AIN coating 801 on a coated 803 carbon structure 805. The coating 803 between the carbon based carbon structures 805 and the polycrystalline AIN 801 can be any refractor metal carbide, nitride, or oxide such as SiC, TaC, NbC, HfN, ZrC and can replace any of the internal reactor parts in FIG 3,4, 6 or 9. The aluminum and gallium metal-chlorides are reacted with the ammonia at the III-Nitride crystal surface 611 to form AlGaN. Reactant gas 615 is a carrier gas to facilitate flow. Reactant gas 611 in this embodiment may be nitrogen, argon, hydrogen, or any inert gas. The reactant gases and their gaseous byproducts are removed from the reactor via the exhaust 617.

The HVPE reactor is heated by an induction coil 619 that is inductively coupled to a susceptor 621. The susceptor is surrounded by thermal insulation 623 to limit heat loss.

HVPE manufacturing of low carbon AIN at high temperature (Embodiment 4)

This example shows how to manufacture low carbon and low silicon AIN III-Nitride crystal using a novel high temperature HVPE method. Figure 9 is a cross-section view of one embodiment. The figure shows a HVPE reactor for low carbon and low silicon AIN III-Nitride crystal production, where the reactor is mounted in a horizontal configuration.

Two hundred grams of aluminum metal is placed in a polycrystalline AIN coated single crystal sapphire boats 901 capable of handling temperatures in excess of 1500° C, The aluminum boat is loaded into concentric polycrystalline AIN coated niobium flow tubes for HCl 903, nitrogen 905, and ammonia 907 inside a polycrystalline AIN coated tungsten process tube 909 of a HVPE reactor [How is boat loaded into tubes.

The intended surface for the production of the AIN crystal 911 is a single crystal AIN substrate mounted on an aluminum-AIN mixture casted body platter 913. The platter is made by mixing aluminum metal with AIN and heated to above 1000C. The plate is placed at a 0 degree orientation. The HVPE reactor is vacuumed to below $1x10^{-2}$ torr and backfilled/purged with nitrogen before pulling another vacuum below $1x10^{-2}$ torr. The reactor is backfilled to a pressure between 1 torr and 2000 torr under a nitrogen environment. The source zone 91 is heated to 1200C and the growth zone 92 is heated to 1800° C. Hydrogen 915 is used as an etchant gas to remove the native oxide or oxy-nitride layer on the AIN substrate. Reactant gases HCl, ammonia and nitrogen are fed into the reactor through their respective concentric flow tubes 903,905, 907. The HCl is reacts with the 200 grams of aluminum to form a metal-chloride. Nitrogen is a carrier gas used to facilitate flow and to keep the flow of metal-chlorides and ammonia separated while exiting the flow tubes. The metal-chloride reacts with the ammonia at the III-Nitride crystal surface 911 to form AIN with a growth rate over 0.1 mm per hour and a final AIN crystal volume of over 3 $mm^3$. The process lasts from 1-500 hours with 24 being preferred. The carrier gas species in this embodiment may be nitrogen, hydrogen, argon, other inert gases, or a mixture of any of these. The reactant gases and their gaseous byproducts are removed from the reactor via the exhaust 917.

Manufacturing of low carbon AIN Substrate templates (Embodiment 5)

This example shows how to manufacture low carbon and low silicon AIN III-Nitride crystal templates on 50 mm sapphire wafers using a novel high temperature HVPE method. Figure 9 is a cross-section view of one embodiment. The figure shows a HVPE reactor for low carbon and low silicon AIN III-Nitride crystal production, where the reactor is mounted in a vertical configuration.

The reactor is prepared as in embodiment 4 but the intended surface for the production of the AIN crystal is a 50 mm single crystal sapphire wafer and where the sapphire wafer is mounted as in embodiment 4. The HVPE reactor is vacuumed to below 1x10-2 torr and backfilled/purged with nitrogen before pulling another vacuum below 1x10-2 torr. The reactor is backfilled to a pressure between 1 torr and 2000 torr under a nitrogen environment. The source zone is heated to 1100C and the growth zone is heated to 1420C. Reactant gases are flowed into the reactor as in embodiment 4. The metal-chloride reacts with the ammonia at the sapphire crystal surface to form a thin AlN layer less then 0.05 mm thick at a growth rate of 0.01-0.2 mm per hour. The HVPE reactor is heated as in embodiment 4 and the reactant gases flows and pressures the same, and their gaseous byproducts are removed as in embodiment 4.

The susceptor may be made of graphite, refractory metals, or other materials capable of induction heating and the meeting the temperature requirements. The heating zone is defined by the induction coil. There may be one or more heating zones. The method of heating may also be resistive heating. The thermal insulation may be altered to achieve a desired temperature profile. The thermal insulation may be altered by removing entirely or changing the size or number of layers.

The benefits of the systems, methods, and crystals disclosed herein are independent of the geometry of the gas flow and the angle at which the substrate is held with respect to the gas flow. The gas flow may be down, up, or horizontal and the substrate may be held horizontal, vertical, or any angle in between. The growth of the substrate may be nucleated on any substrate including crystallographic materials such as sapphire, silicon carbide, gallium nitride, aluminum nitride, or others. The growth of the substrate X01 may also be nucleated on any substrate including freely nucleated on polycrystalline or amorphous materials such as tungsten, or zirconium.

Manufacturing of low carbon AlN Substrate in bulk (Embodiment 6)

This embodiment, as shown in FIG. 18, shows how to manufacture low carbon and low silicon AlN III-Nitride crystal substrates. The diameter of the III-Nitride crystal ranges from approximately 25 mm to over 150 mm. The III-Nitride crystals are sliced 1801 to a thickness of 3 millimeter or less, preferably around 0.3 mm or less, by using any method but a state-of-the-art wire saw is preferred to produce a rough substrate. Unnecessary protrusions that have formed at the edge of the rough substrate during the slicing process or during growth are removed by edge cutting, grinding, and polishing 1802. The edge-finished substrate is loaded into a horizontal rotating plate for rough polishing or grinding on both sides of the substrate while liquid polishing agents are poured between the substrate and the plate 1803 . The substrate is heat treated in high temperatures under nitrogen to remove the processing strain that occurred during the prior processes and to prevent warping or other distortions that may occur during future processes 1804. The annealed substrate is loaded into a polisher where a single side of the annealed substrate is mechanically polished using successively smaller hard diamond abrasives 1805. The mechanically polished substrate is chemically-mechanically polished by using soft silica particles in a predetermined Ph slurry in the range of 7-14 until the required surface roughness is achieved resulting in a finished III-Nitride crystal substrate 1806. The finished substrates are precision washed in a clean environment using pure water to remove any foreign matter from the surface 1807 , then packaged 1808 for use in A UV semiconductor device consisting of at least one PN junction such as an LED, laser diodes or photo detectors or any other power electronic semiconductor device such as mosfet HFET 1809.

Manufacturing of low carbon freestanding AlN Substrates in bulk (Embodiment 7)

This embodiment, as shown in FIGS. 10-11, shows how to manufacture low carbon and low silicon free standing AlN III-Nitride crystal substrates 1101 removed form the seed 1102 used to produce them. This allows for carbon rich seed without sufficient optical transparency to be used in the production of low carbon and low silicon AlN III-Nitride crystal with out adverse effects on the UV transparency causing a cutoff above 300 nm.

The AlN III-Nitride crystal 1001 attached to seed 1002 is loaded into a horizontal rotating plate for grinding on the seed side 1002 of the AlN III-Nitride crystal while liquid polishing agents are poured between the seed side and the plate 1901. Chemical agents of a predetermined pH in the range of 7-14 are used to accelerate the grinding until the seed is completely removed. The freestanding substrate then can go through the process detailed in embodiment 5

FIG. 16 depicts an embodiment, similar to embodiment 2 or 3 or 4, above, where a showerhead 16 is used in place of flow channels 405, 407, 423, 605, 607, 623 or flow tubes 907, 903, 905 to introduce gaseous source material 1604, 1605, 1606 into a vapor deposition reactor. The showerhead includes inlet assemblies 1607 that connect the inlet gas lines to the showerhead. The showerhead includes a gas dispersion feature 1603 on the downstream face of the showerhead that optimizes the flow of gaseous material into the reaction chamber 1601 and on to the III-Nitride growth surface. The showerhead can be heated by induction or any other suitable heating method to increases the temperature of the gaseous material and increase the temperature uniformity across the III-Nitride growth surface 411,611,911,1001 that allows a uniform, near isothermal, 2D heat distribution across the surface of the III-Nitride growth surface 411,611,911,1001, 1611. The heat is radiated parallel to the surface of the substrate instead of axially radiated heating or bottom-through conducted heating. This parallel heating allows for a more isothermal temperature distribution across the substrate surface, which in turn allows for radial scaling of the substrate beyond 2" in diameter. This heat is most preferably supplied by an induction heating coil 1610 and heat baffle susceptor 1609. The induction coil is most preferably place in a flat or pancake configuration on top of the heat baffle susceptor. This leads to a large but predictable temperature gradient in the X-Z and Y-Z planes but allows a near isothermal 2D heating of the XY plane parallel to the surface of the crystal substrate. Thus external from a susceptor 409, 609, 909 as used in embodiment 2 or 3 or 4 can be used in conjunction with this method In comparison to either parallel-axially radiated heating or bottom-through conducted heating, top down parallel heating allows near unlimited isotheral scaling in the plane parallel to the crystal's surface.

In various embodiments, the III Nitride crystals and III-Nitride crystal substrates disclosed herein may be used on a variety of applications, devices, and semiconductor configurations. By way of example, the crystals and substrates of the present disclosure may be used in LEDs, Laser Diodes, Photo Detectors, Schottky Diodes, Power Switches, HFETS MFETS, MIS, MOSFETS BAW SAW and PyroElectric Devices, among others.

Additional features of the systems, methods, devices, and other disclosures herein may also be found in the various novel and prior art disclosures of the attached Appendices A, B, and C, the entire contents of which are incorporated herein in their entireties by reference.

It will be appreciated that the devices and methods of the present disclosure are directed to a composition of matter, process, machine, article of manufacture, and the use of the article, as well as being capable of incorporation in the form of a variety of embodiments, only a few of which have been illustrated and described above. The disclosures herein may be embodied in other specific forms without departing from its spirit or essential characteristics. The described embodiments are to be considered in all respects only as illustrative and not restrictive and the scope of the present disclosure is, therefore indicated by the appended claims rather than by the foregoing description. All changes that come within the meaning and range of equivalency of the claims are to be embraced within their scope.

Although the above detailed embodiments contains many specifics, these should not be construed as limiting the scope of the invention but merely as illustrating different examples and aspects of the invention. It should be appreciated that the scope of the invention includes other embodiments not discussed in detail above. Various other modifications, changes, and variations that will be apparent to those skilled in the art may be made in the arrangement, operation, and details of the method and apparatus of the present invention disclosed herein without departing from the spirit and scope of the invention as defined in the appended claims. Therefore, the scope of the invention should be determined by the appended claims and their legal equivalents. Furthermore, no element, component or method step is intended to be dedicated to the public regardless of whether the element, component or method step is explicitly recited in the claims.

Other aspects and embodiments of the invention are described in the following clauses:

1. A III-Nitride crystal with a carbon concentration below $2\times10^{18}$ atoms/cm$^3$ whereby the III-Nitride crystal is sufficiently UV transparent below 300 nm.

2. A III-Nitride crystal of clause 1 that is non-stoichiometric consisting essentially of the formula $In_{(w)}Al_{(x)}Ga_{(y)}C_{(a)}N_{(z)}$ where $1\text{-}x\text{-}w \neq y$, $w\text{-}z\text{-}y\neq0$, $w+x+y\text{-}z\neq0$, $(2\geq w\geq0)$, $(2\geq x\geq0)$, $(2\geq y\geq0)$, $(2\geq z\geq0)$, ($a\leq2\times10^{18}$ atoms/cm$^3$), whereby the III-Nitride crystal is sufficiently UV transparent below 300 nm and of a size larger then 1 mm$^2$.

3. A III-Nitride crystal with a silicon concentration below $2\times10^{18}$ atoms/cm$^3$ whereby the III-Nitride crystal is sufficiently UV transparent below 300 nm.

4. A III-Nitride crystal of clause 3 that is non-stoichiometric consisting essentially of the formula $In_{(w)}Al_{(x)}Ga_{(y)}Si_{(b)}N_{(z)}$ where $1\text{-}x\text{-}w \neq y$, $w\text{-}z\text{-}y\neq0$,$w+x+y\text{-}z\neq0$, $(2\geq w\geq0)$, $(2\geq x\geq0)$, $(2\geq y\geq0)$, $(2\geq z\geq0)$, ($b\leq2\times10^{18}$ atoms/cm$^3$), whereby the III-Nitride crystal is sufficiently UV transparent below 300 nm and of a size larger then 1 mm$^2$.

5. A III-Nitride crystal with a carbon concentration below $2\times10^{18}$ atoms/cm$^3$, a silicon concentration below $2\times10^{18}$ atoms/cm$^3$ whereby the III-Nitride crystal is sufficiently UV transparent below 300 nm.

6. A III-Nitride crystal of clause 5 that is non-stoichiometric consisting essentially of the formula $In_{(w)}Al_{(x)}Ga_{(y)}C_{(a)}Si_{(b)}N_{(z)}$ where $1\text{-}x\text{-}w \neq y$, $w\text{-}z\text{-}y\neq0$,$w+x+y\text{-}z\neq0$, $(2\geq w\geq0)$, $(2\geq y\geq0)$, $(2\geq y\geq0)$, $(2\geq z\geq0)$, ($a\leq2\times10^{18}$ atoms/cm$^3$), ($b\leq2\times10^{18}$ atoms/cm$^3$), whereby the III-Nitride crystal is sufficiently UV transparent below 300 nm and of a size larger then 1 mm$^2$.

7. A III-Nitride crystal of clause 1 or 5, wherein the carbon concentration can be located in any position within said III-Nitride crystal.

8. A III-Nitride crystal of clause 3 or 5, wherein the silicon concentration can be located in any position within said III-Nitride crystal.

9. A III-Nitride crystal according to clause 1 or 3 or 5 with a volume larger then $700^{-5}$ $mm^3$.

10. A III-Nitride crystal according to clause 1 or 3 or 5 with a volume larger then 3 $mm^3$.

11. A method of manufacturing said III-Nitride crystal according to clause 1 or 3 or 5 comprising of vapor phase reaction of at least one group III and one nitrogen species.

12. A method of manufacturing said III-Nitride crystal according to clause 1 or 3 or 5 comprising of vapor phase reaction of at least one group III and one nitrogen species by physical vapor deposition.

13. A method of manufacturing said III-Nitride crystal according to clause 1 or 3 or 5 comprising of vapor phase reaction of at least one group III and one nitrogen species by physical vapor deposition wherein the internal components are not made in whole and/or in part with carbon.

14. A method of manufacturing said III-Nitride crystal according to clause 1 or 3 or 5 comprising of vapor phase reaction of at least one group III and one nitrogen species by CVD.

15. A method of manufacturing said III-Nitride crystal according to clause 1 or 3 or 5 comprising of vapor phase reaction of at least one group III and one nitrogen species by HVPE.

16. A method of manufacturing said III-Nitride crystal according to clause 1 or 3 or 5 comprising of vapor phase reaction of at least one group III and one nitrogen species by HVPE, wherein the internal components are not made in whole and/or part with carbon.

17. A method of manufacturing said III-Nitride crystal according to clause 1 or 3 or 5 comprising of vapor phase reaction of at least one group III and one nitrogen species by HVPE wherein the internal temperature of the HVPE reactor is 1300 C or above, the internal temperature of the growth zone is 1300 C or above, the internal temperature of the source zone is between 700-1500 C, the internal components are capable of withstanding temperatures in excess of 1500 C.

18. A method of manufacturing said III-Nitride crystal according to clause 1 or 3 or 5 comprising of vapor phase reaction of at least one group III and one nitrogen species by HVPE wherein the internal temperature of the HVPE reactor is 1300 C or above, the internal temperature of the growth zone does not excided 2450 C or above, the internal temperature of the source zone is between 700-1500 C, the internal components are capable of withstanding temperatures up to 2450 C.

19. A method of manufacturing said III-Nitride crystal according to clause 1 or 3 or 5 comprising of vapor phase reaction of at least one group III and one nitrogen species comprising of HVPE wherein a III-Nitride crystal having a volume larger then $700^{-5}$ $mm^3$ is used to seed the growth.

20. A method of manufacturing said III-Nitride crystal according to clause 1 or 3 or 5 comprising of vapor phase reaction of at least one group III and one nitrogen species comprising of HVPE wherein a III-Nitride crystal having a volume larger then 0.1 $mm^3$ is used to seed the growth.

21. A method of manufacturing said III-Nitride crystal according to clause 1 or 3 or 5 comprising of vapor phase reaction of at least one group III and one nitrogen species by HVPE wherein a foreign material is used to seed the growth.

22. A method of manufacturing said III-Nitride crystal according to clause 1 or 3 or 5 comprising of vapor phase reaction of at least one group III and one nitrogen species by HVPE wherein a III-Nitride crystal is used to seed the growth and is removed to create a free standing III-Nitride crystal according to clause 1 or 3 or 5.

23. A method of clause 22 wherein the remove consists of mechanically removing said seed.

24. A method of clause 22 wherein the remove consists of thermally removing said seed.

25. A method of clause 22 wherein the remove consists of chemically removing said seed.

26. A method of clause 22 wherein the remove consists of mechanically, chemically and/or thermally removing said seed.

27. A method of manufacturing said III-Nitride crystal according to clause 1 or 3 or 5 comprising of vapor phase reaction of at least one group III and one nitrogen species by HVPE wherein a III-Nitride crystal is used to seed the growth and is not removed to create a thin III-Nitride crystal according to clause 1 or 3 or 5.

28. A method of growing a III-Nitride crystal with a carbon concentration below $2\times10^{18}$ atoms/cm$^3$ whereby the III-Nitride crystal is sufficiently UV transparent below 300 nm, wherein AlN is used in a polycrystalline form as the internal components of a high temperature HVPE (HT-HVPE) reactor for the growth of III-Nitride crystal material for semiconductor devices.

29. A method according to clause 28 wherein the AlN internal components can be a freestanding polycrystalline AlN body.

30. A method according to clause 28 wherein the AlN internal components are coated with a polycrystalline AlN of sufficient thickness.

31. A method according to clause 28 wherein the internal components are capable of withstanding temperatures in excess of 1400 C.

32. A method according to clause 28 wherein the internal components are capable of withstanding temperatures in excess of 1600 C.

33. A method according to clause 28 wherein the internal components are capable of withstanding temperatures in excess of 1700 C.

34. A method according to clause 28 wherein the internal components are capable of withstanding temperatures in excess of 1900 C.

35. A method according to clause 28 wherein the AlN internal components can be a reinforced by a backing material.

36. A method according to clause 28 wherein the AlN internal components can be a reinforced by a preformed reinforcing support material.

37. A method according to clause 28 wherein the AlN internal components can be a polycrystalline AlN coating on a coated carbon structure.

a. wherein a carbon structure is a carbon-based article that can be of any suitable shape size or volume in any form or physical density used for producing an internal component in part or in whole of a HVPE reaction. This includes Metal Matrix Composites and Ceramic Matrix Composites structure that are in part carbon based.

38. A method according to clause 28 wherein the AlN internal components can be a polycrystalline AlN coating on refractory metal carbide coated carbon structure.

39. A method according to clause 28 wherein the AlN internal components can be a polycrystalline AlN coating on boron nitride coated carbon structure.

40. A method according to clause 28 wherein the AlN internal components can be a polycrystalline AlN coating on a silicon carbide coated carbon structure.

41. A method according to clause 28 wherein the AlN internal components can be a polycrystalline AlN coating on aluminum nitride-silicon carbide alloy coated carbon structure.

42. A method according to clause 28 wherein the AlN internal components can be a polycrystalline graded aluminum nitride-silicon carbide alloy coated carbon structure wherein the percent of silicon carbide in the alloy is high near the carbon structure and is reduced to zero as the coating is produced thicker such that the silicon carbide percentage is nearly zero at the coatings external surface.

43. A method according to clause 28 wherein the AIN internal components can be a polycrystalline AIN coating on an uncoated carbon structure.

44. A method according to clause 28 wherein the method consists of at least a source zone and a growth zone.

45. A method according to clause 28 wherein the AIN internal components can be reinforced by a metal filler.

46. A method according to clause 28 wherein the AIN internal components can be a compositional mixture of metal and AIN.

47. A method according to clause 28 wherein the AIN internal components can be an aluminum and AIN powder cast form.

48. A method according to clause 28 wherein the AIN internal components can be a metal matrix composite mixture of metal and AIN.

49. A method according to clause 28 wherein the AIN internal components can be a compositional mixture of a refractory metal and AIN.

50. A method according to clause 28 wherein the internal temperature of the HVPE reactor is 1350 C or above.

51. A method according to clause 28 wherein the internal temperature of the growth zone is 1350 C or above.

52. A method according to clause 28 wherein the internal temperature of the source zone is between 700-1500 C.

53. A method according to clause 23 wherein the internal components in the source zone are capable of withstanding temperatures in excess of 1500 C and the internal components in the growth zone are capable of withstanding temperatures in excess of 1900 C.

54. A method according to clause 28 wherein the internal component surfaces decompose in to constituent species of the gas phase components in the HVPE reaction.

55. A method according to clause 28 wherein the production rate of said III-Nitride crystal is above 0.01 mm/h.

56. A method according to clause 23 wherein the production rate of said III-Nitride crystal is at least 0.1 mm/h.

57. A method according to clause 28 wherein the volume of said III-Nitride crystal is at least $700^{-5}$ $mm^3$.

58. A method according to clause 28 wherein the volume of said III-Nitride crystal is over 1 $mm^3$.

59. A method of manufacturing said III-Nitride crystal according to clause 1 or 3 or 5 comprising of vapor phase reaction of at least one group III and one nitrogen species by CVD wherein the said III-Nitride crystal thickness is below 0.1 mm.

60. A method of manufacturing said III-Nitride crystal according to clause 1 or 3 or 5 comprising of vapor phase reaction of at least one group III and one nitrogen species by HVPE wherein the said III-Nitride crystal thickness is below 0.1 mm.

61. A method of manufacturing said III-Nitride crystal according to clause 1 or 3 or 5 comprising of vapor phase reaction of at least one group III and one nitrogen species by CVD wherein the said III-Nitride crystal thickness is 0.1 mm-1 mm.

62. A method of manufacturing said III-Nitride crystal according to clause 1 or 3 or 5 comprising of vapor phase reaction of at least one group III and one nitrogen species by HVPE wherein the said III-Nitride crystal thickness is 0.1 mm-1 mm.

63. A method of manufacturing said III-Nitride crystal according to clause 1 or 3 or 5 comprising of vapor phase reaction of at least one group III and one nitrogen species by CVD wherein the said III-Nitride crystal thickness is over 1 mm.

64. A method of manufacturing said III-Nitride crystal according to clause 1 or 3 or 5 comprising of vapor phase reaction of at least one group III and one nitrogen species by HVPE wherein the said III-Nitride crystal thickness is over 1 mm.

65. A method of manufacturing said III-Nitride crystal according to clause 1 or 3 or 5 comprising of vapor phase reaction of at least one group III and one nitrogen species by physical vapor deposition wherein the said III-Nitride crystal thickness is over 0.01 mm.

66. A III-Nitride crystal substrate with a carbon concentration below $2\times10^{18}$ atoms/cm$^3$ with a thickness of over 0.01 mm, whereby the III-Nitride crystal is sufficiently UV transparent below 300 nm.

67. A III-Nitride crystal substrate with a silicon concentration below $2\times10^{18}$ atoms/cm$^3$ with a thickness of over 0.01 mm, whereby the III-Nitride crystal is sufficiently UV transparent below 300 nm.

68. A method of manufacturing a said III-Nitride crystal substrate of clause 65 or 66 comprising of at least one grinding, cutting, polishing, or surface treating step of a III-Nitride crystal with a carbon and/or silicon concentration below $2\times10^{18}$ atoms/cm$^3$ whereby the III-Nitride crystal is sufficiently UV transparent below 300 nm.

69. A method of manufacturing a said III-Nitride crystal substrate of clause 65 or 66 comprising of placing a III-Nitride crystal with a carbon and/or silicon concentration below $2\times10^{18}$ atoms/cm$^3$ whereby the III-Nitride crystal is sufficiently UV transparent below 300 nm on a suitable substrate.

70. A method of clause 1 or 2 or 5, where a showerhead is used in a HVPE reactor to introduce gaseous source material on the downstream face of the showerhead that optimizes the flow of gaseous material on to the III-Nitride growth surface. The showerhead can be heated by induction or any other suitable heating method to increases the temperature of the gaseous material and increase the temperature uniformity across the III-Nitride growth surface.

71. A method of clause 70 that heats said showerhead in such a way that allows a uniform, near isothermal, 2D heat distribution across the surface of the III-Nitride growth crystal.

72. A method of clause 70 where in the showerhead can be heated by induction or any other suitable heating method to increases the temperature of the gaseous material and increase the temperature uniformity across the III-Nitride growth surface.

73. A method according to clause 28 where a showerhead is used in a HVPE reactor to introduce gaseous source material on the downstream face of the showerhead that optimizes the flow of gaseous material on to the III-Nitride growth surface. The showerhead can be heated by induction or any other suitable heating method to increases the temperature of the gaseous material and increase the temperature uniformity across the III-Nitride growth surface, wherein the showerhead can be heated by induction or any other suitable heating method to increases the temperature of the gaseous material and increase the temperature uniformity across the III-Nitride growth surface, that heats said showerhead in such a way that allows a uniform, near isothermal, two-dimensional heat distribution across the surface of the III-Nitride growth crystal.

74. A III-Nitride crystal according to clause 1 or 3 or 5 with a volume larger then $2^{-5}$ mm$^3$.

75. A III-Nitride crystal according to clause 1 or 3 or 5 with a volume larger then $0.2^{-5}$ mm$^3$.

76. A method of manufacturing said III-Nitride crystal according to clause 1 or 3 or 5 comprising of vapor phase reaction of at least one group III and one nitrogen species comprising of HVPE wherein a III-Nitride crystal having a volume larger then $2^{-5}$ mm$^3$ is used to seed the growth.

77. A method of manufacturing said III-Nitride crystal according to clause 1 or 3 or 5 comprising of vapor phase reaction of at least one group III and one nitrogen species comprising of HVPE wherein a III-Nitride crystal having a volume larger then $0.2^{-5}$ mm$^3$ is used to seed the growth.

78. A method according to clause 28 wherein the volume of said III-Nitride crystal is at least $2^{-5}$ mm$^3$.

79. A method according to clause 28 wherein the volume of said III-Nitride crystal is at least $0.2^{-5}$ $mm^3$.

80. A method according to clause 28 wherein the AIN internal components can be a polycrystalline AIN coating on Metal Matrix Composites structure.

a. An article of clause (above) where the Metal Matrix Composites structure is carbon based.

81. A method according to clause 28 wherein the AIN internal components can be a polycrystalline AIN coating on Ceramic Matrix Composites structure.

a. An article of clause (above) where the Ceramic Matrix Composites structure is carbon based.

82. Wherein the carbon structures of clause 37 or 38 or 39 or 40 or 41 or 42 or 43 can be of any suitable shape size or volume in any form or physical density used for producing an internal component in part or in whole of a HVPE reactor.

83. A UV semiconductor device consisting of at lest one PN junction on a III-Nitride crystal with a carbon concentration below $2\times10^{18}$ atoms/$cm^3$ whereby the III-Nitride crystal is sufficiently UV transparent below 300 nm.

84. A UV semiconductor device consisting of at lest one PN junction on a III-Nitride crystal substrate of clause 65 or 66 with a carbon concentration below $2\times10^{18}$ atoms/$cm^3$ whereby the III-Nitride crystal is sufficiently UV transparent below 300 nm.

85. A UV semiconductor device consisting of at lest one PN junction produced on a III-Nitride crystal substrate of clause 65 or 66 with a carbon concentration below $2\times10^{18}$ atoms/$cm^3$ whereby the III-Nitride crystal is sufficiently UV transparent below 300 nm wherein the substrate has been removed.

86. A UV semiconductor device consisting of at lest one PN junction produced by a III-Nitride crystal with a carbon concentration below $2\times10^{18}$ atoms/$cm^3$ whereby the III-Nitride crystal is sufficiently UV transparent below 300 nm.

87. A UV semiconductor device consisting of at lest one PN junction produced by a III-Nitride crystal with a carbon concentration below $2\times10^{18}$ atoms/$cm^3$ whereby the III-Nitride crystal is sufficiently UV transparent below 300 nm wherein the substrate has been removed.

88. A III-Nitride crystal according to clause 1 or 3 or 5 with a volume larger then $2^{-5}$ $mm^3$.

89. A III-Nitride crystal according to clause 1 or 3 or 5 with a diameter larger then 1 mm.

90. A III-Nitride crystal according to clause 1 or 3 or 5 with a diameter larger then 10 mm.

91. A III-Nitride crystal according to clause 1 or 3 or 5 with a diameter larger then 50 mm.

92. A III-Nitride crystal according to clause 1 or 3 or 5 with a diameter larger then 200 mm.

93. A method of manufacturing said III-Nitride crystal according to clause 1 or 3 or 5 comprising of vapor phase reaction of at least one group III and one nitrogen species comprising of HVPE wherein a III-Nitride crystal having a diameter larger then 1 mm is used to seed the growth.

94. A method of manufacturing said III-Nitride crystal according to clause 1 or 3 or 5 comprising of vapor phase reaction of at least one group III and one nitrogen species comprising of HVPE wherein a III-Nitride crystal having a diameter larger then 10 mm is used to seed the growth.

95. A method of manufacturing said III-Nitride crystal according to clause 1 or 3 or 5 comprising of vapor phase reaction of at least one group III and one nitrogen species comprising of HVPE wherein a III-Nitride crystal having a diameter larger then 50 mm is used to seed the growth.

96. A method of manufacturing said III-Nitride crystal according to clause 1 or 3 or 5 comprising of vapor phase reaction of at least one group III and one nitrogen species comprising of HVPE wherein a III-Nitride crystal having a diameter larger then 200 mm is used to seed the growth.

97. A method according to clause 28 wherein the diameter of said III-Nitride crystal is at least 1 mm.

98. A method according to clause 28 wherein the diameter of said III-Nitride crystal is at least 10 mm.

99. A method according to clause 28 wherein the diameter of said III-Nitride crystal is at least 50 mm.

100. A method according to clause 28 wherein the diameter of said III-Nitride crystal is at least 200 mm.

## Claims

**1.** A group III-Nitride crystal comprising:

a lattice structure having by a at least one of a carbon concentration less than about $2*10^{18}$ atoms/$cm^3$ or a silicon concentration less than about $2*10^{18}$ atoms/$cm^3$ ; wherein the group III-Nitride crystal is UV transparent at or below a wavelength of approximately 300 nm.

**2.** The group III-Nitride crystal of claim 1 wherein the crystal is non-stoichiometric.

**3.** The group III-Nitride crystal of claim 1 or claim 2 wherein the crystal has a formula of $In_{(w)}Al_{(x)}Ga_{(y)}C_{(a)}Si_{(b)}N_{(z);}$ wherein 1-x-w≠y, w-z-y≠0,w+x+y-z≠0, (2≥w≥0), (2≥x≥0), (2≥y≥0), (2≥z≥0), (a≤$2*10^{18}$ atoms/$cm^3$), (b≤$2*10^{18}$ atoms/$cm^3$),; and the crystal has at least one surface with an area greater than 1 $mm^2$.

**4.** The group III-Nitride crystal of any preceding claim wherein the carbon concentration can be located in any position within the lattice structure.

**5.** The group III-Nitride crystal of any preceding claim, wherein the silicon concentration can be located in any position within the lattice structure.

**6.** The group III-Nitride crystal of any preceding claim, wherein the crystal has a volume of approximately $700^{-5}$ $mm^3$ or greater.

**7.** A method of manufacturing a group III-Nitride crystal by chemical vapor deposition (CVD) wherein carbon is not introduced into the crystal; the method comprising:

providing a group-III source in a substantially carbon-free reactor; wherein the carbon-free reactor does not contain exposed carbon;
heating the group-III source;
introducing a nitride source;
maintaining a temperature gradient having a minimum temperature of at least 1300° C; and
cooling the group III-Nitride crystal.

**8.** The method of claim 7, wherein the temperature gradient comprises:

a first temperature of 1300 C or greater above in a growth zone; and
a second temperature between about 400-1500 C in a source zone; wherein all internal components of the reactor are capable of withstanding temperatures in excess of 1700°C.

**9.** A group III-Nitride crystal obtainable by the process of claim 7 or claim 8 wherein a seed crystal having a volume larger then $700^{-5}$ $mm^3$ is the group-III source.

**10.** The group III-Nitride crystal of claim 9, wherein a substrate crystal is used to seed the growth of the group-III Nitride crystal.

**11.** The group III-Nitride crystal of claim 10, wherein the substrate crystal is removed after growth to provide a freestanding III-Nitride crystal.

**12.** The group III-Nitride crystal of any one of claims 9 to 11 wherein the group III-Nitride crystal is UV transparent at or below a wavelength of approximately 300 nm.

**13.** The group III-Nitride crystal obtained by the process of claim 10 further comprising:

the group III-Nitride crystal; wherein the group-III crystal is UV transparent at or below a wavelength of approximately 300 nm and a group III-Nitride substrate crystal is used as the group-III source;
wherein the group III-Nitride substrate crystal is removed to provide a free standing group III-Nitride crystal; and wherein the substrate crystal is removed by at least one of mechanical, thermal, or chemically removal.

**14.** A reactor for manufacturing a group III-Nitride crystal by chemical vapor deposition comprising: one or more internal components consisting of polycrystalline AlN.

**15.** The reactor of claim 14 wherein the reactor further comprises at least one internal component coated with a polycrystalline AlN having a thickness of at least 10 microns.

**16.** The reactor of any one of claims 12 to 15 wherein the one or more internal components further comprise a reinforcing support material.

**17.** A UV semiconductor device comprising:

at least one PN junction formed on at least one of a group III-Nitride crystal or a group III-Nitride crystal substrate having at least one or a carbon concentration or a silicon concentration less than about $2*10^{18}$ atoms/$cm^3$ ; wherein the group III-Nitride crystal is UV transparent at or below about 300 nm.

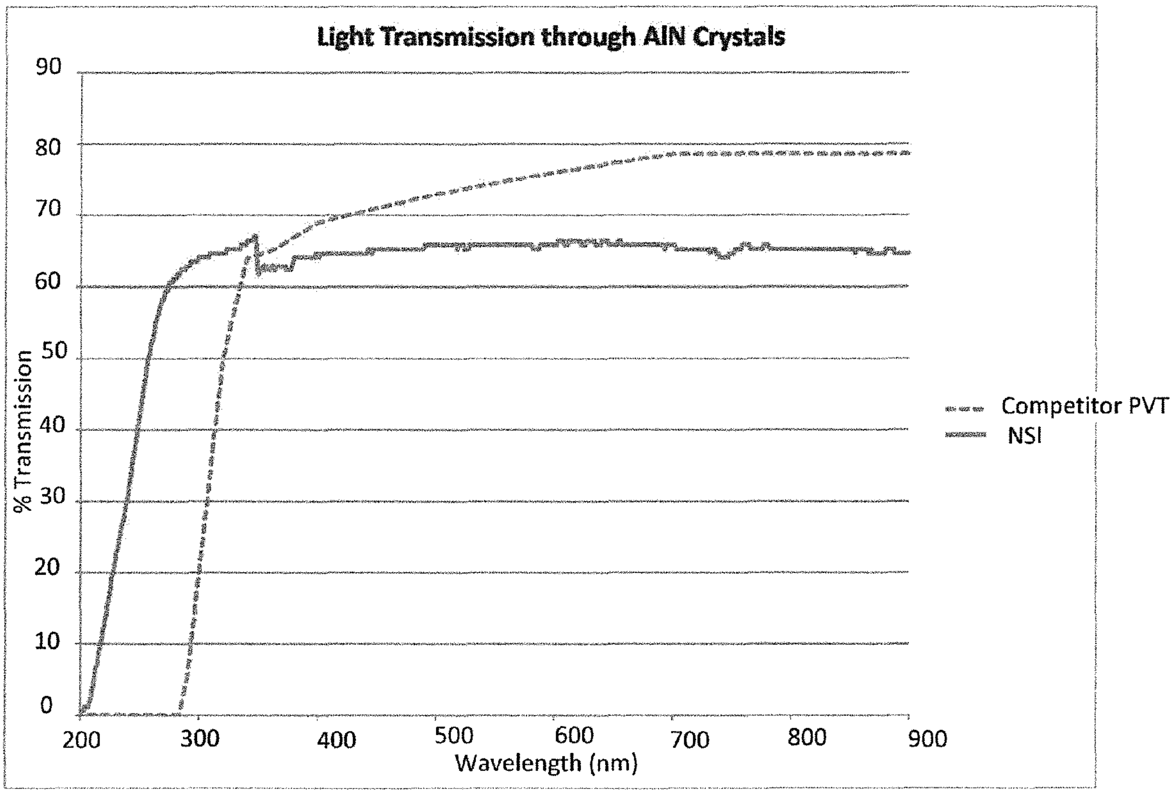
Light Transmission through AlN Crystals
90
80
70
60
50
40
30
20
10
0
% Transmission
200
300
400
500
600
700
800
900
Wavelength (nm)
Competitor PVT
NSI

FIG. 1

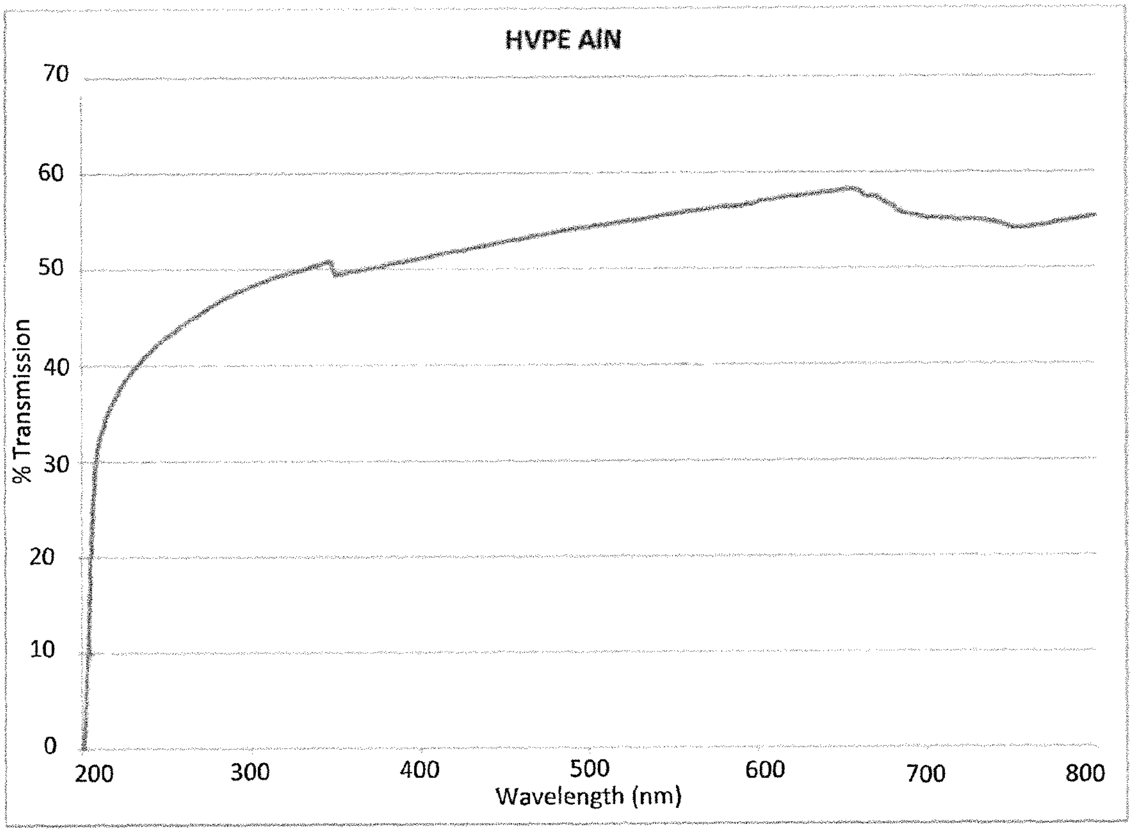
HVPE AlN
% Transmission
70
60
50
40
30
20
10
0
200
300
400
500
600
700
800
Wavelength (nm)

FIG. 2

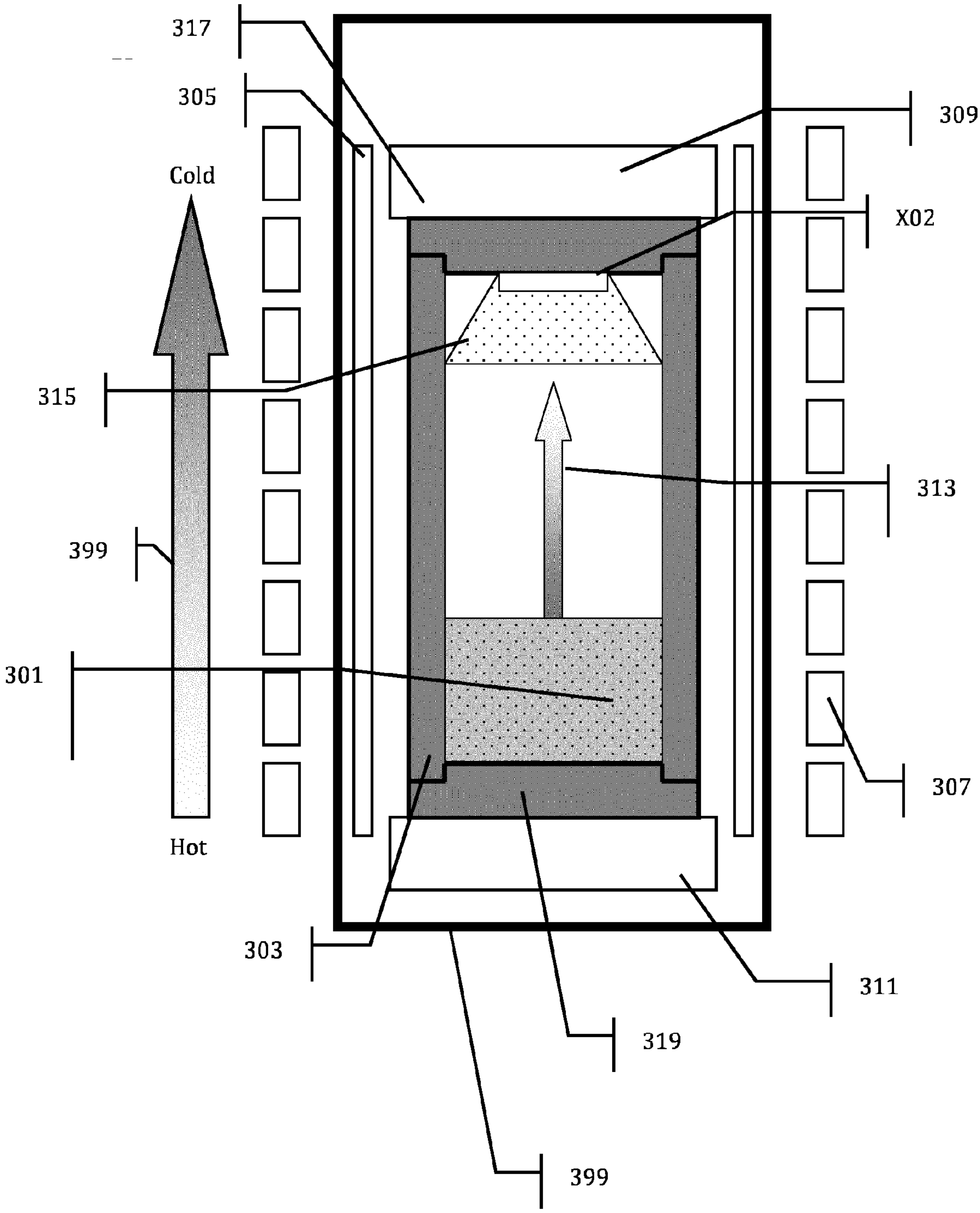


FIG. 3

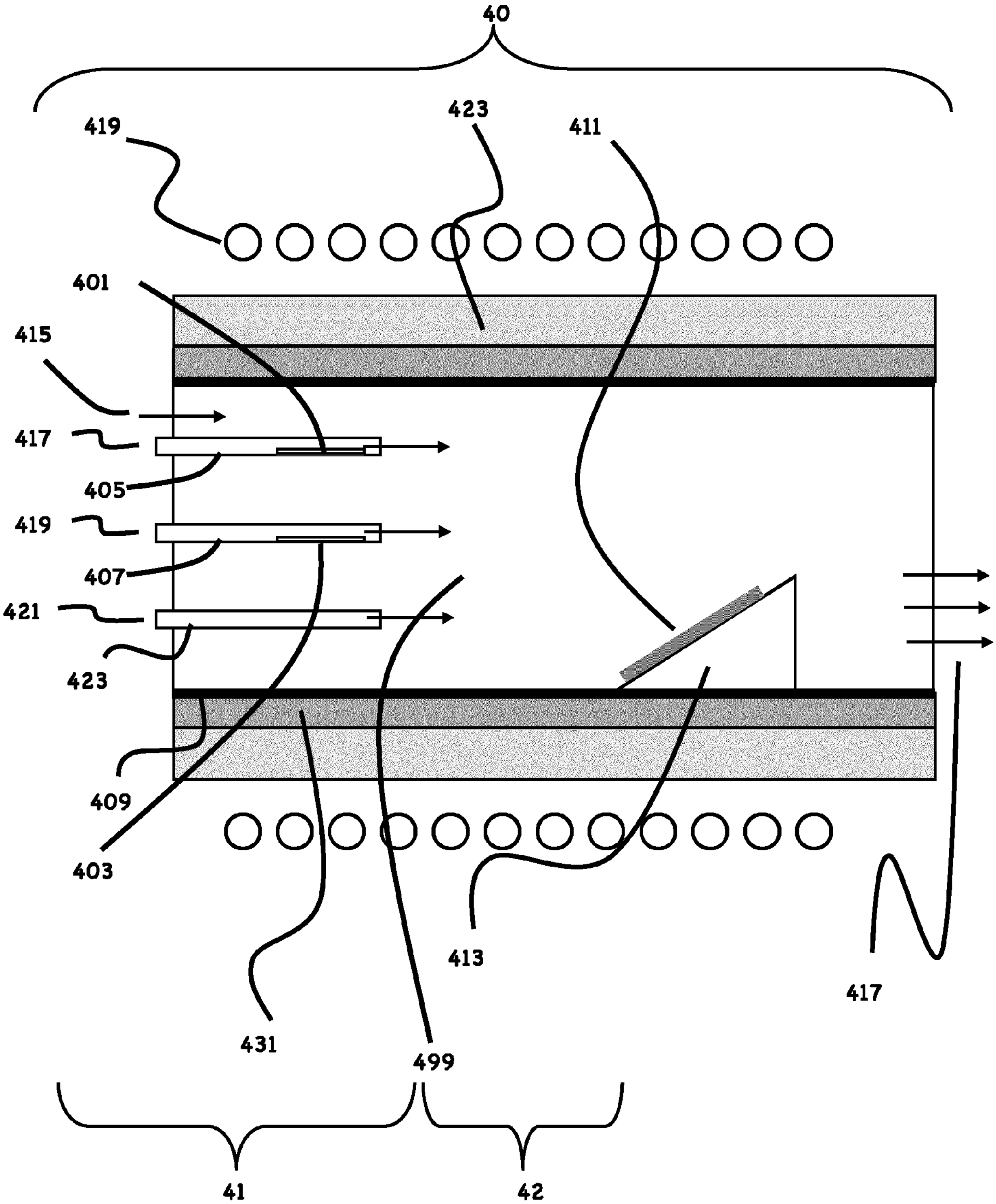
40
419
423
411
401
415
417
405
419
407
421
423
409
403
413
417
431
499
41
42

FIG. 4

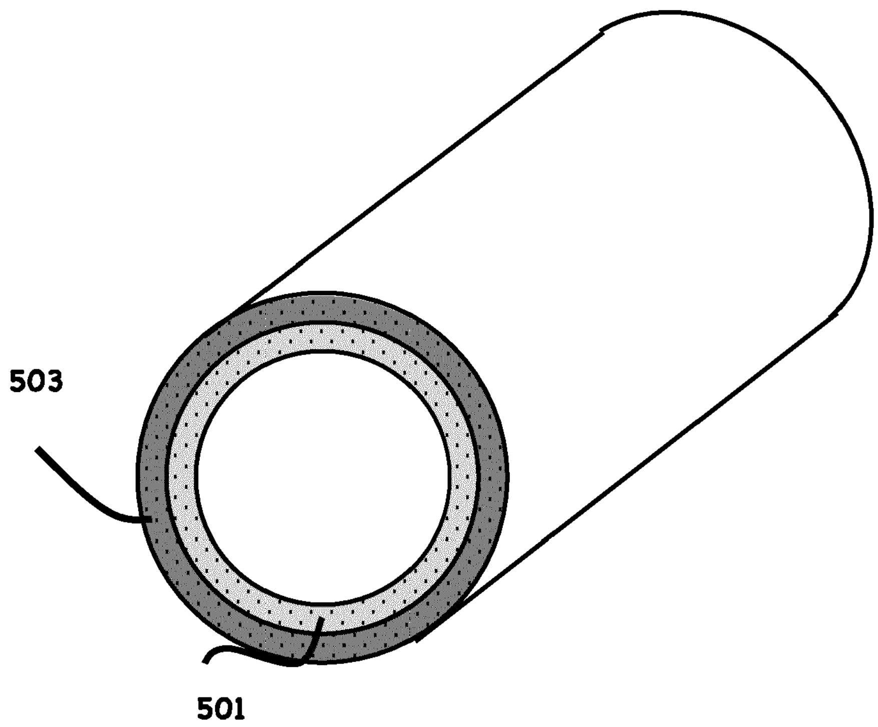


FIG. 5

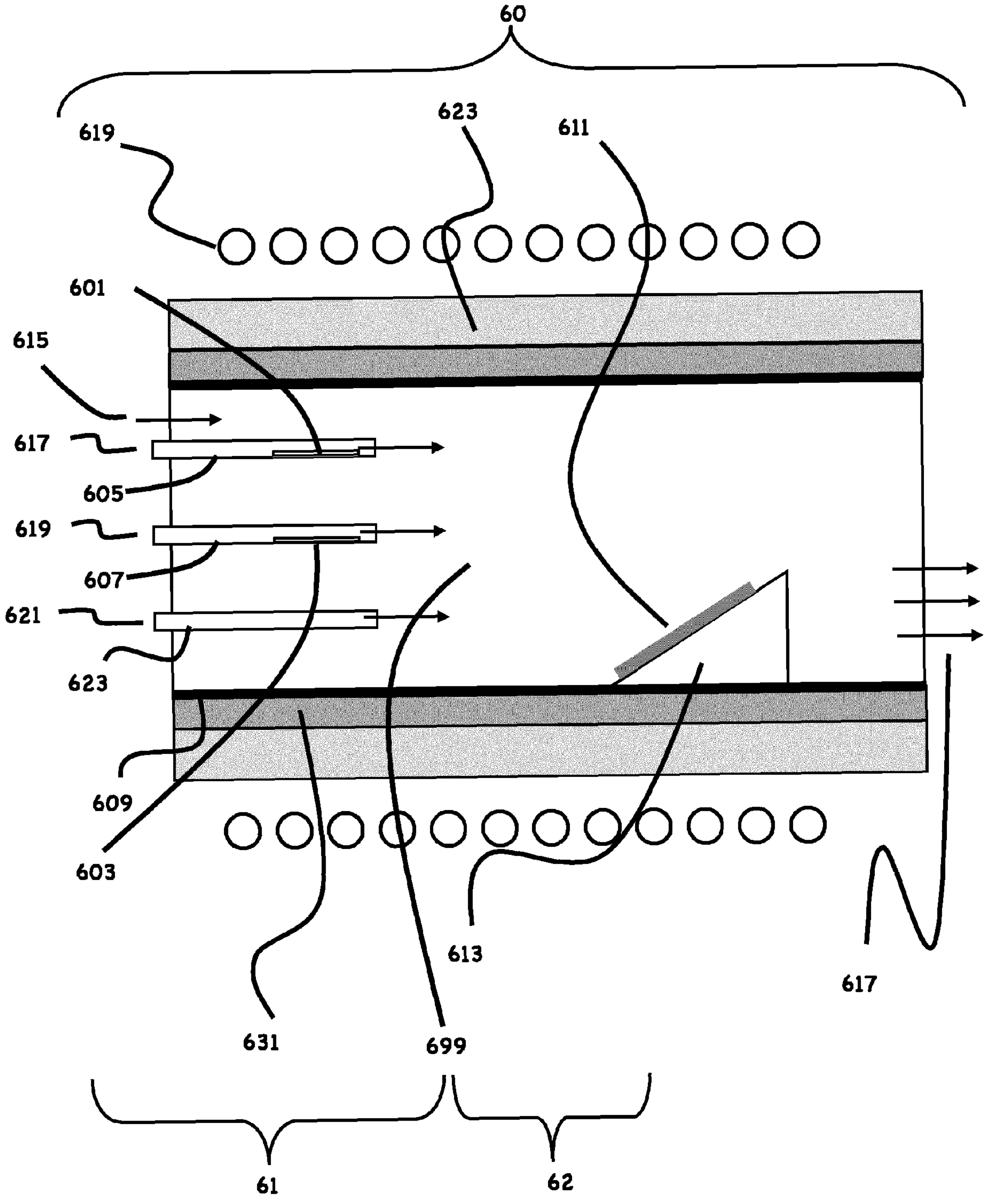
60
619
623
611
601
615
617
605
619
607
621
623
609
603
631
699
613
617
61
62

FIG. 6

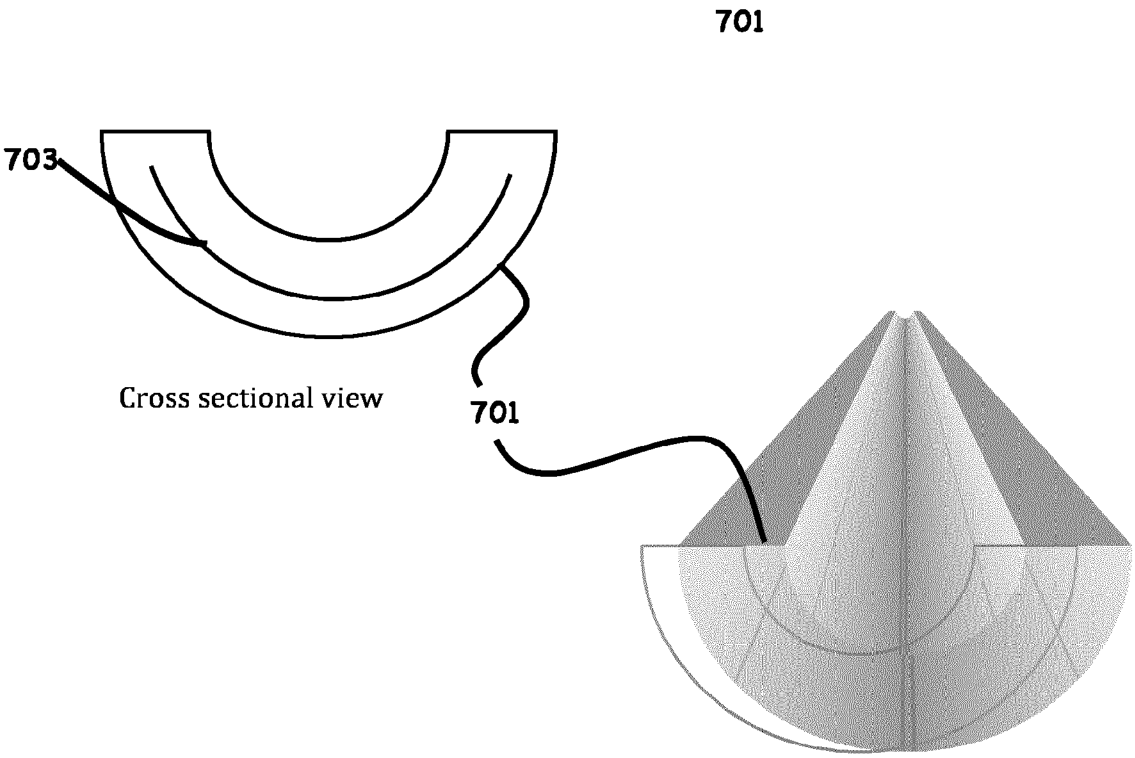


FIG. 7

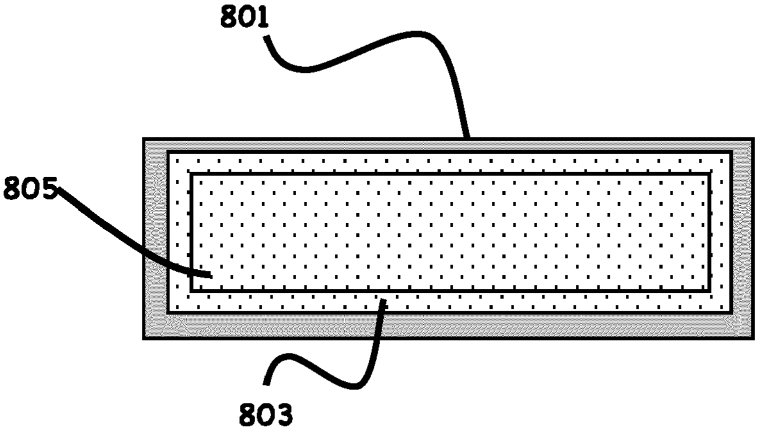


FIG. 8

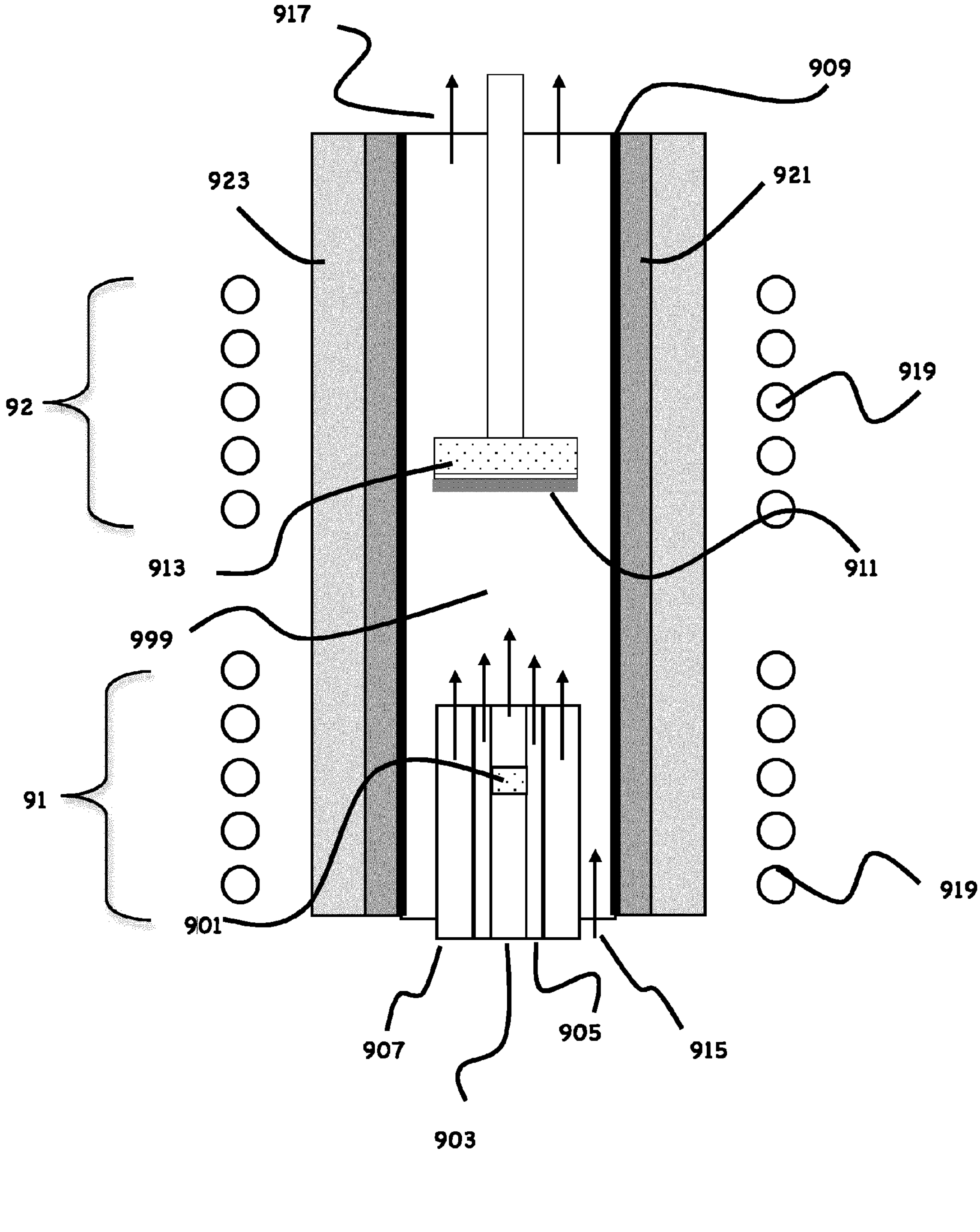


FIG. 9A

Part of Fig 9

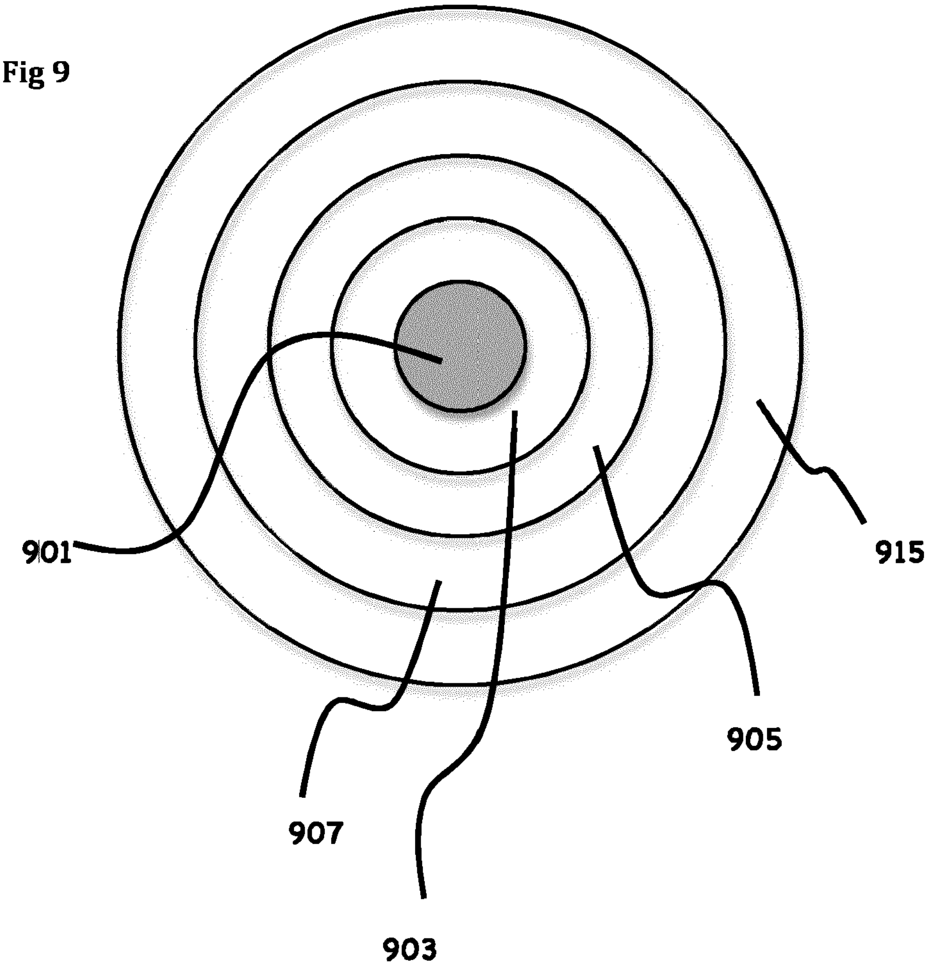


FIG. 9B

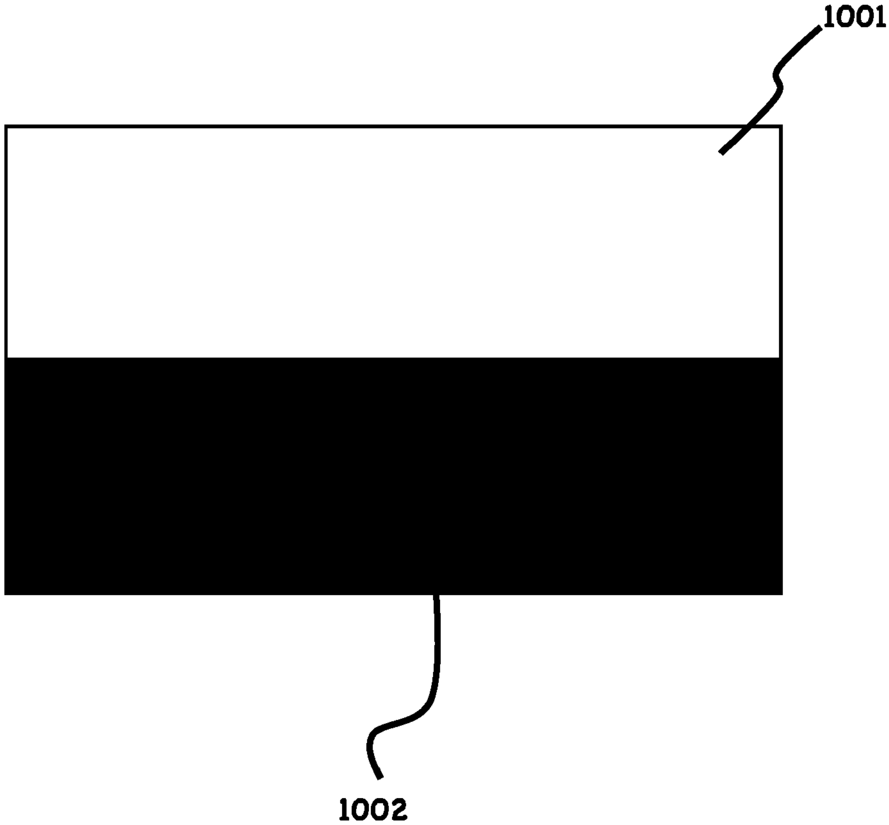


FIG. 10

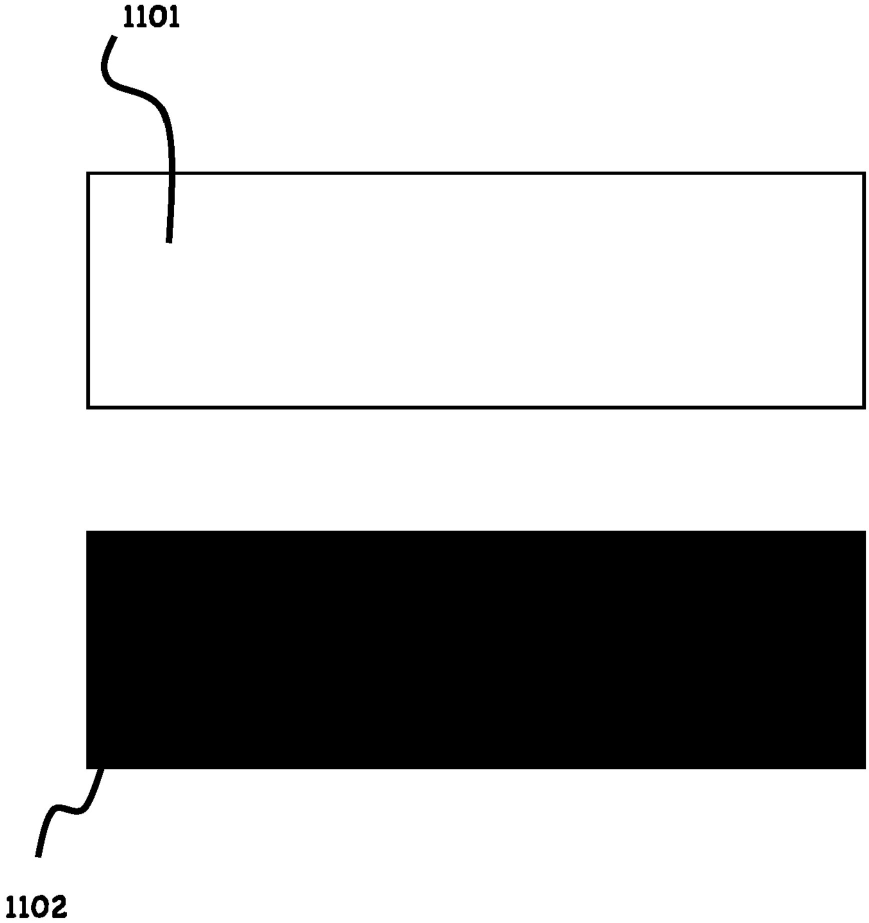


FIG. 11

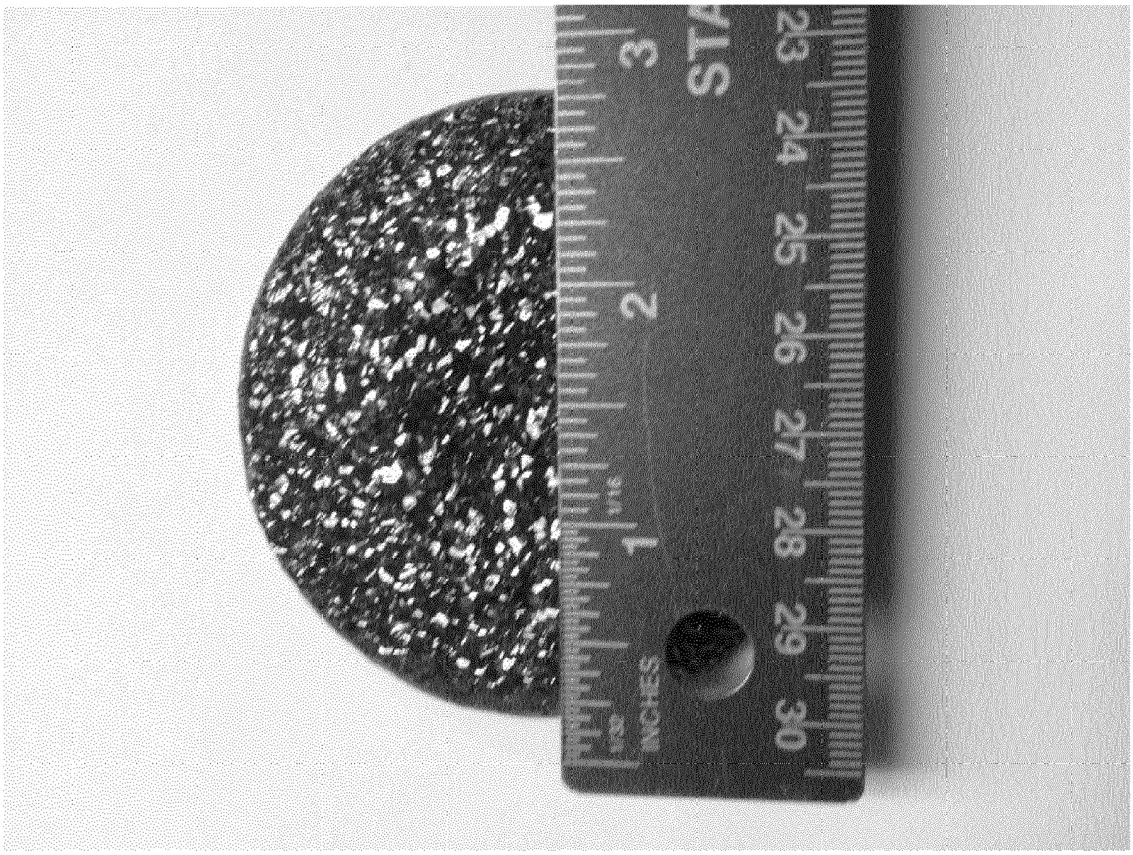

FIG. 12

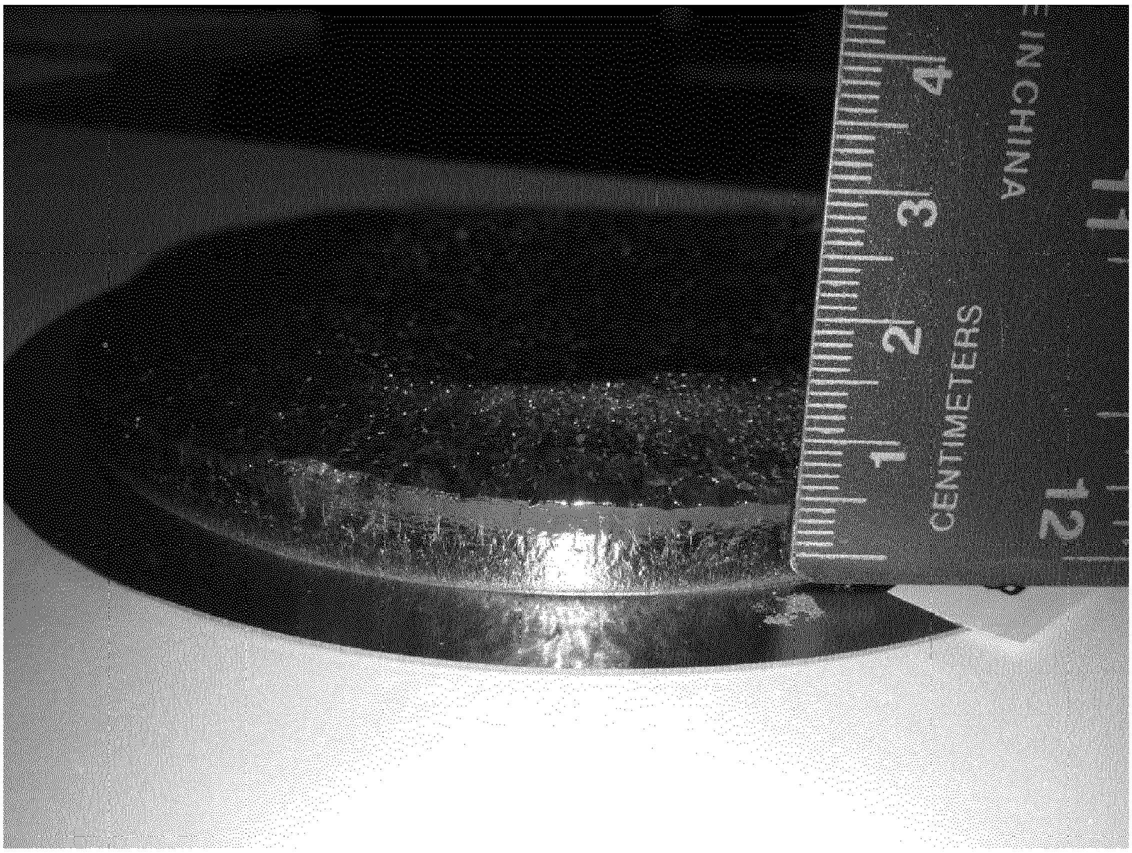


FIG. 13

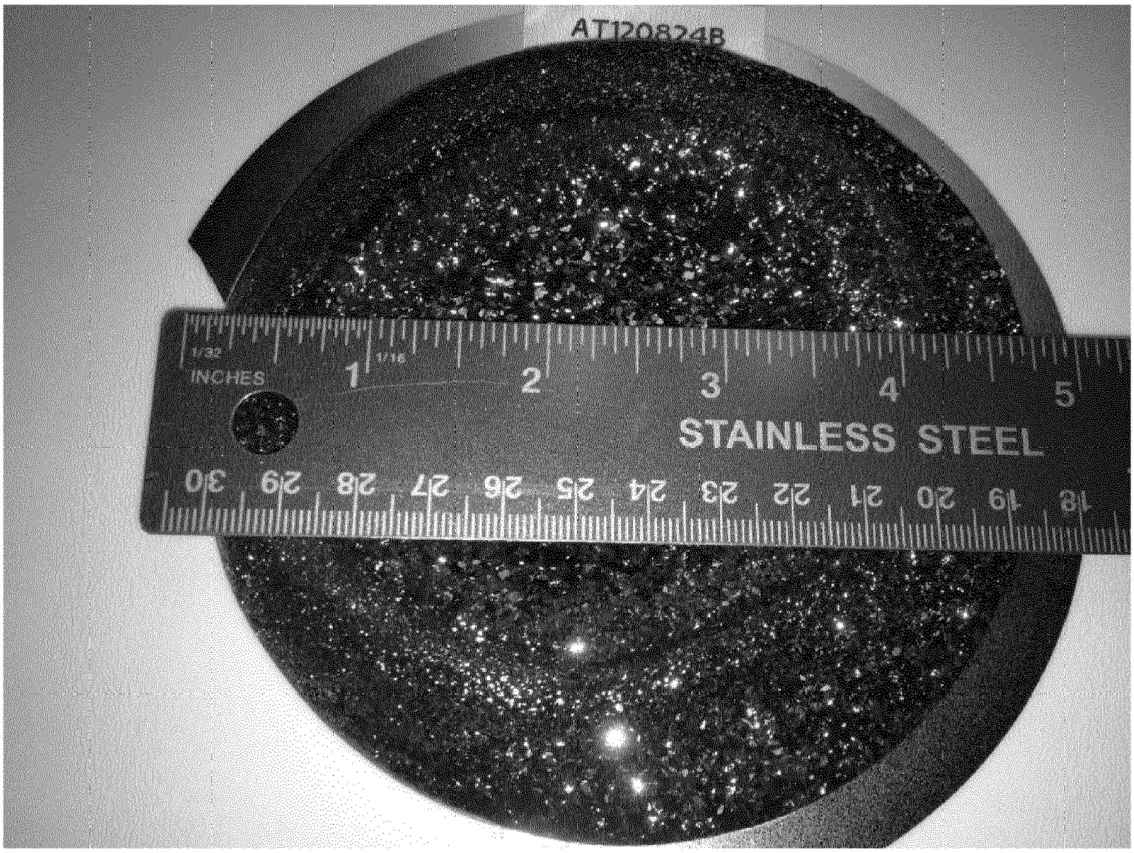
AT120824B
INCHES
1/32
1/16
1
2
3
4
5
STAINLESS STEEL
30
29
28
27
26
25
24
23
22
21
20
19
18

FIG. 14

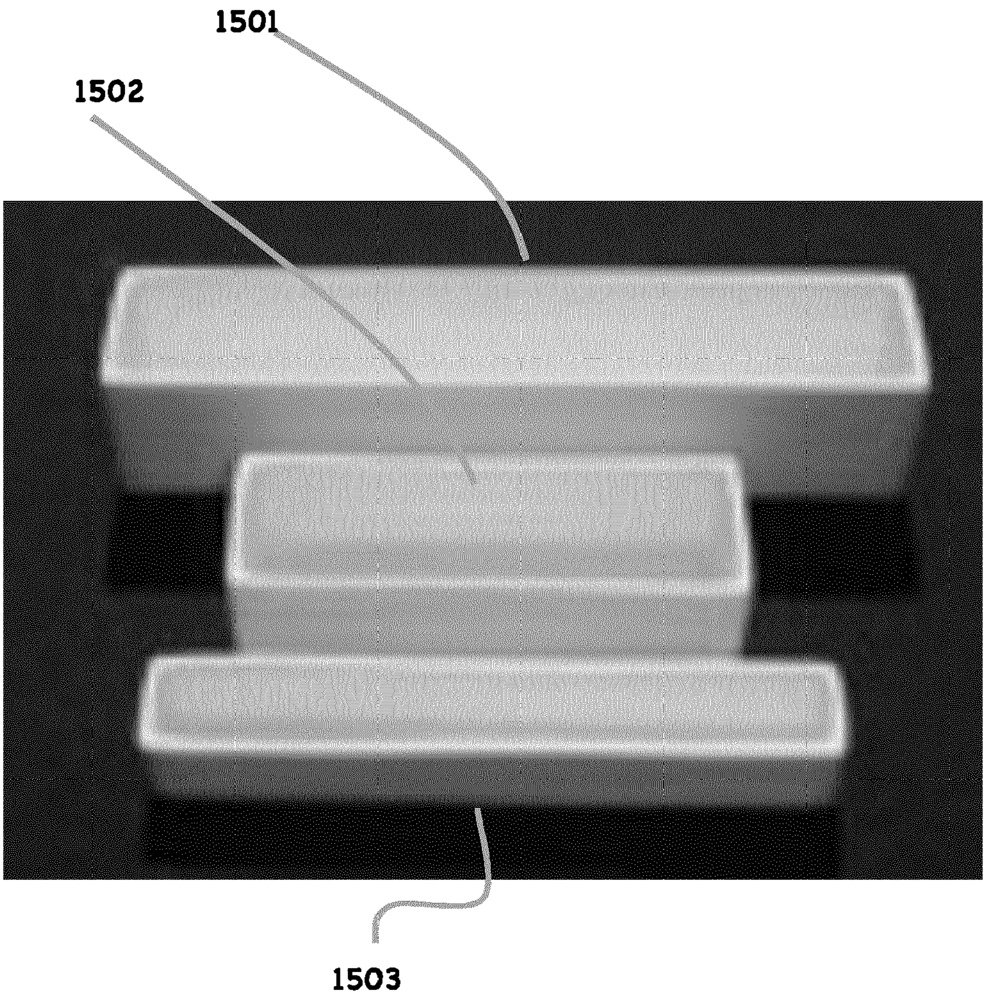


FIG. 15

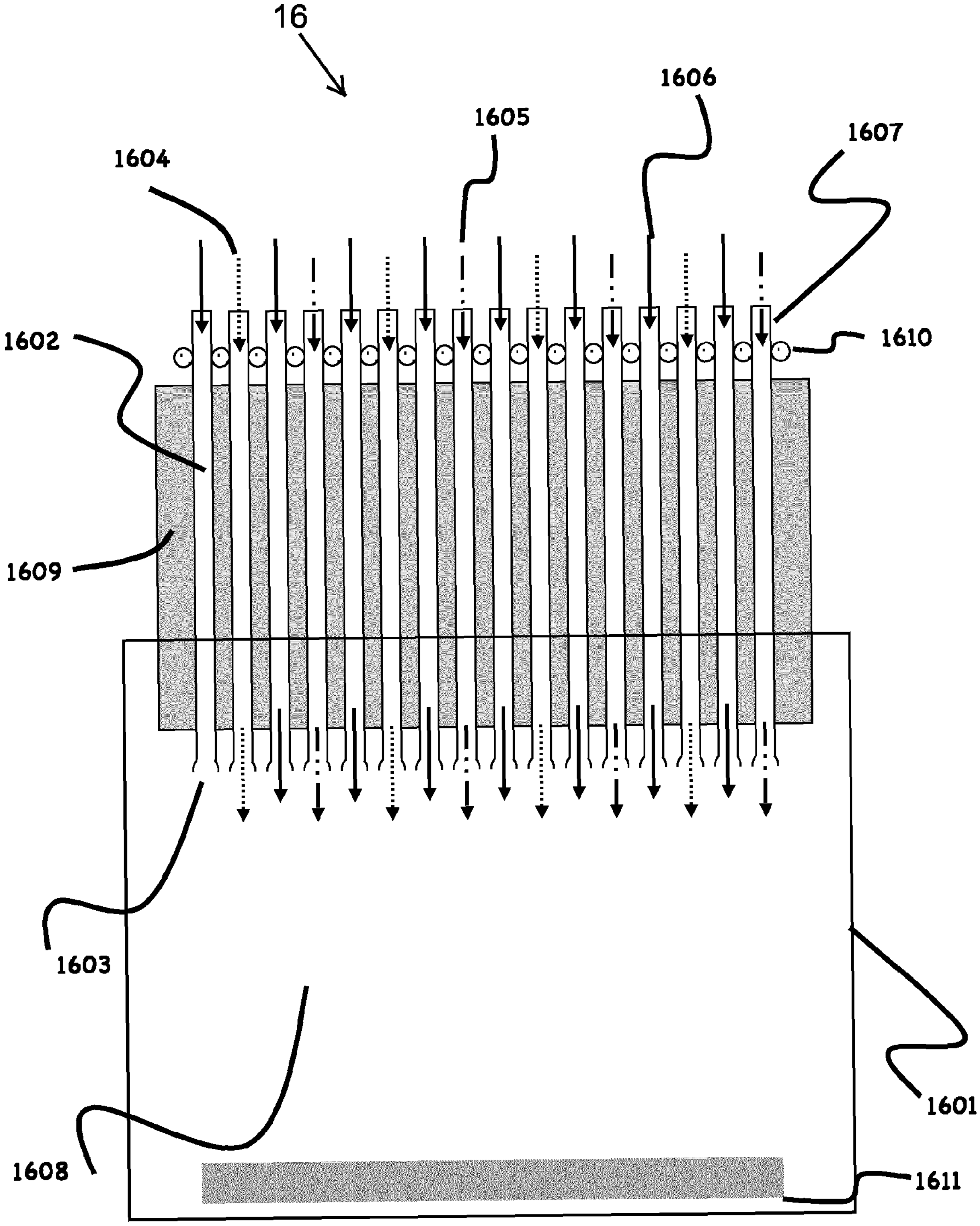


FIG. 16

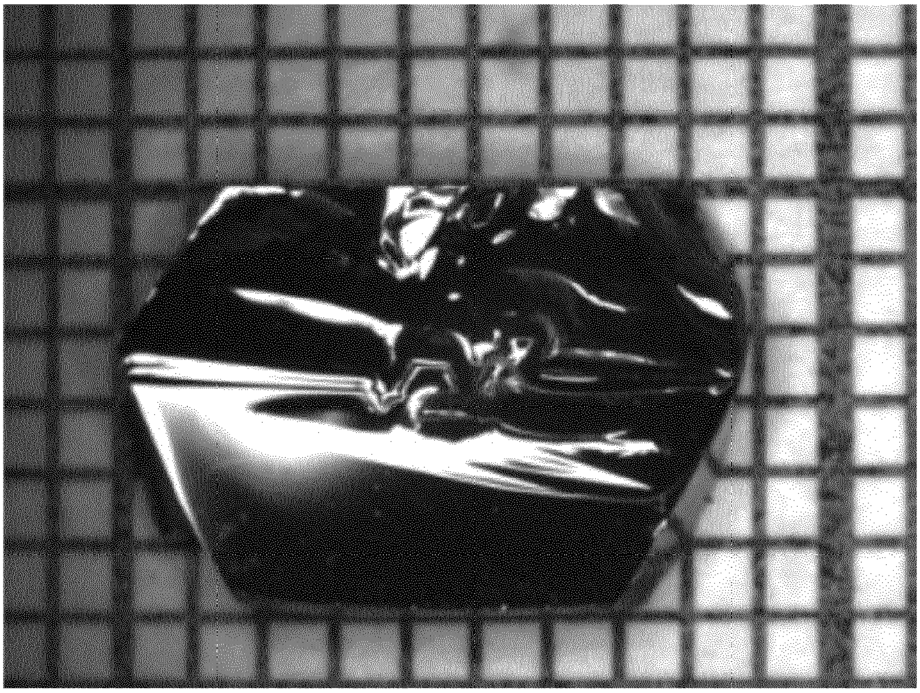

FIG. 17

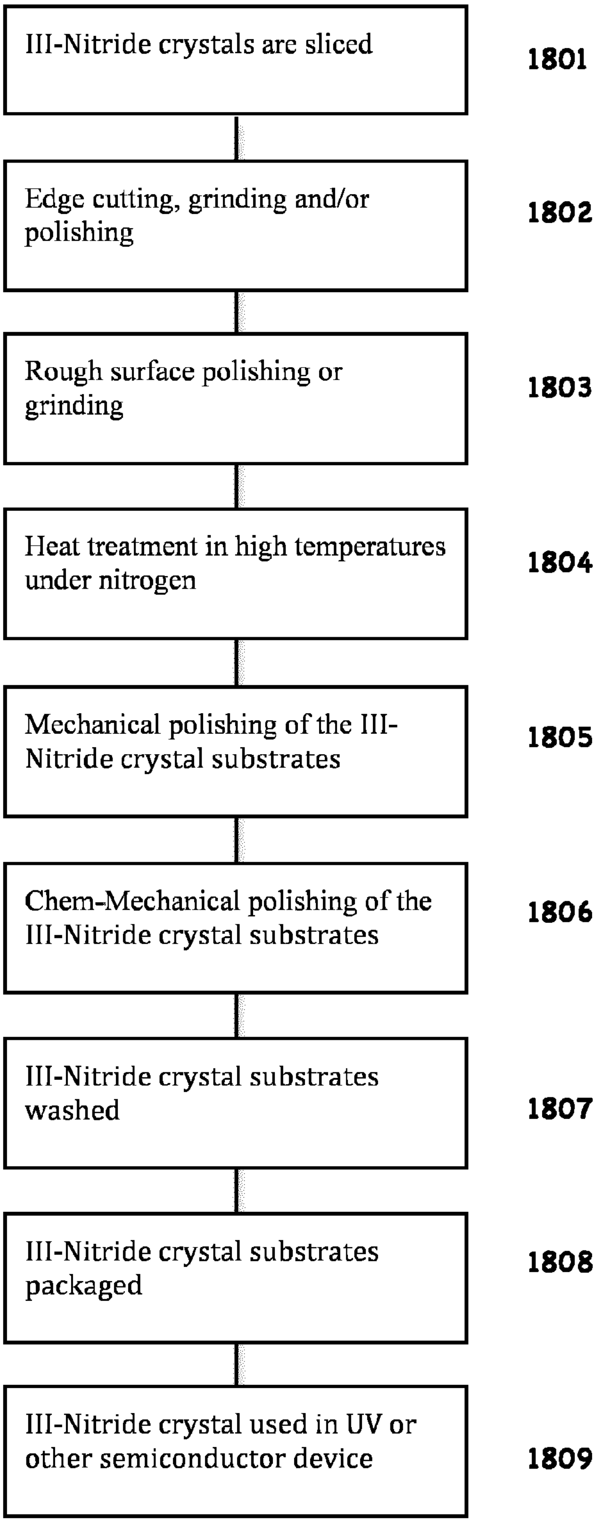
III-Nitride crystals are sliced
1801
Edge cutting, grinding and/or polishing
1802
Rough surface polishing or grinding
1803
Heat treatment in high temperatures under nitrogen
1804
Mechanical polishing of the III-Nitride crystal substrates
1805
Chem-Mechanical polishing of the III-Nitride crystal substrates
1806
III-Nitride crystal substrates washed
1807
III-Nitride crystal substrates packaged
1808
III-Nitride crystal used in UV or other semiconductor device
1809

FIG. 18

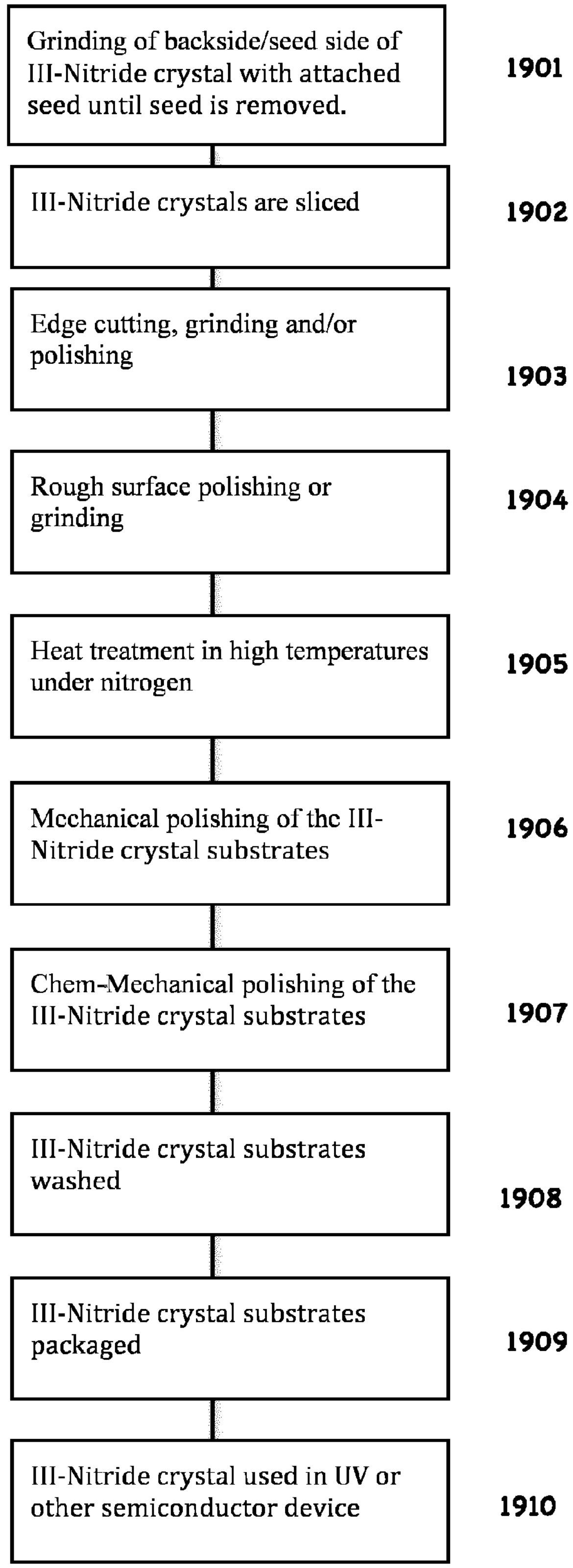
Grinding of backside/seed side of III-Nitride crystal with attached seed until seed is removed.
1901
III-Nitride crystals are sliced
1902
Edge cutting, grinding and/or polishing
1903
Rough surface polishing or grinding
1904
Heat treatment in high temperatures under nitrogen
1905
Mechanical polishing of the III-Nitride crystal substrates
1906
Chem-Mechanical polishing of the III-Nitride crystal substrates
1907
III-Nitride crystal substrates washed
1908
III-Nitride crystal substrates packaged
1909
III-Nitride crystal used in UV or other semiconductor device
1910

FIG. 19

Europäisches Patentamt
European Patent Office
Office européen des brevets

# EUROPEAN SEARCH REPORT

Application Number
EP 14 15 9915

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>Y<br>A | US 2012/076968 A1 (DMITRIEV VLADIMIR A [US] ET AL) 29 March 2012 (2012-03-29)<br>* paragraph [0101] - paragraph [0106]; claims 1-9, 12; figures 1,4-7; examples 5,6 *<br>----- | 1,4-6, 13,17<br>9-13<br>2,3,14 | INV.<br>C30B29/403<br>C30B29/406<br>C30B25/08<br>C30B23/00<br>C30B23/06<br>C30B29/40 |
| X<br>Y<br>A | EP 1 160 354 A1 (MATSUSHITA ELECTRIC IND CO LTD [JP]) 5 December 2001 (2001-12-05)<br>* paragraph [0001] - paragraph [0006]; figure 1 *<br>* paragraphs [0021], [0034], [0043], [0049] - paragraph [0051] *<br>* paragraph [0071] - paragraph [0079] *<br>----- | 14-16<br>9-13<br>1-6,17 | |
| Y | EP 1 624 095 A2 (SUMITOMO ELECTRIC INDUSTRIES [JP])<br>8 February 2006 (2006-02-08)<br>* claims 1-4; figure 1 *<br>* paragraph [0018] - paragraph [0021] *<br>----- | 7,8 | |
| Y | K. TSUJISAWA ET AL: "High temperature growth of AlN film by LP-HVPE",<br>PHYSICA STATUS SOLIDI (C),<br>vol. 4, no. 7, 1 June 2007 (2007-06-01), pages 2252-2255, XP055125804,<br>ISSN: 1610-1634, DOI: 10.1002/pssc.200674814<br>* abstract *<br>* page 2255, paragraph 1; figures 3,5 *<br>----- | 7,8 | TECHNICAL FIELDS SEARCHED (IPC)<br>C30B |
| A | US 2011/008621 A1 (SCHUJMAN SANDRA B [US] ET AL) 13 January 2011 (2011-01-13)<br>* paragraphs [0008], [0051] - paragraph [0055]; claims 1-15; figures 6,4 *<br>-----<br>-/-- | 1-6,17 | |

The present search report has been drawn up for all claims

12

| Place of search | Date of completion of the search | Examiner |
|---|---|---|
| The Hague | 2 July 2014 | Aliouane, Nadir |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches Patentamt
European Patent Office
Office européen des brevets

# EUROPEAN SEARCH REPORT

Application Number
EP 14 15 9915

| DOCUMENTS CONSIDERED TO BE RELEVANT | | | |
|---|---|---|---|
| Category | Citation of document with indication, where appropriate, of relevant passages | Relevant to claim | CLASSIFICATION OF THE APPLICATION (IPC) |
| A | EP 2 390 386 A1 (SUMITOMO ELECTRIC INDUSTRIES [JP]) 30 November 2011 (2011-11-30) * claims 4,7,9-10 * ----- | 1-6 | |
| A | WO 2006/040359 A1 (AZZURRO SEMICONDUCTORS AG [DE]; DADGAR ARMIN [DE]; KROST ALOIS [DE]) 20 April 2006 (2006-04-20) * paragraphs [0005], [0011], [0051], [0057] - paragraph [0060]; figure 1 * ----- | 7-16 | |
| A | US 2011/171462 A1 (SATOH ISSEI [JP] ET AL) 14 July 2011 (2011-07-14) * paragraphs [0002], [0005], [0011], [0040], [0050], [0069], [0092] * ----- | 7-16 | |
| A | EP 2 314 738 A1 (SUMITOMO ELECTRIC INDUSTRIES [JP]) 27 April 2011 (2011-04-27) * claims 1-9 * ----- | 1-6 | |
| | | | TECHNICAL FIELDS SEARCHED (IPC) |

The present search report has been drawn up for all claims

| Place of search | Date of completion of the search | Examiner |
|---|---|---|
| The Hague | 2 July 2014 | Aliouane, Nadir |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

12
EPO FORM 1503 03.82 (P04C01)

## ANNEX TO THE EUROPEAN SEARCH REPORT ON EUROPEAN PATENT APPLICATION NO. EP 14 15 9915

This annex lists the patent family members relating to the patent documents cited in the above-mentioned European search report. The members are as contained in the European Patent Office EDP file on
The European Patent Office is in no way liable for these particulars which are merely given for the purpose of information.

02-07-2014

| Patent document cited in search report | Publication date | Patent family member(s) | Publication date |
|---|---|---|---|
| US 2012076968 A1 | 29-03-2012 | NONE | |
| EP 1160354 A1 | 05-12-2001 | EP 1160354 A1 | 05-12-2001 |
| | | JP 2001345268 A | 14-12-2001 |
| | | TW 508839 B | 01-11-2002 |
| | | US 2001047750 A1 | 06-12-2001 |
| EP 1624095 A2 | 08-02-2006 | CN 1734719 A | 15-02-2006 |
| | | CN 101503824 A | 12-08-2009 |
| | | EP 1624095 A2 | 08-02-2006 |
| | | JP 2006044982 A | 16-02-2006 |
| | | KR 20060048978 A | 18-05-2006 |
| | | TW I352376 B | 11-11-2011 |
| | | US 2006027896 A1 | 09-02-2006 |
| | | US 2012118226 A1 | 17-05-2012 |
| US 2011008621 A1 | 13-01-2011 | NONE | |
| EP 2390386 A1 | 30-11-2011 | CN 102159755 A | 17-08-2011 |
| | | EP 2390386 A1 | 30-11-2011 |
| | | JP 5418210 B2 | 19-02-2014 |
| | | JP 2010184857 A | 26-08-2010 |
| | | KR 20110116114 A | 25-10-2011 |
| | | US 2011265709 A1 | 03-11-2011 |
| | | WO 2010082574 A1 | 22-07-2010 |
| WO 2006040359 A1 | 20-04-2006 | AT 541963 T | 15-02-2012 |
| | | CA 2583592 A1 | 20-04-2006 |
| | | CN 101080516 A | 28-11-2007 |
| | | DE 102004050806 A1 | 16-11-2006 |
| | | EP 1805353 A1 | 11-07-2007 |
| | | HK 1112268 A1 | 20-07-2012 |
| | | JP 2008516877 A | 22-05-2008 |
| | | KR 20070084283 A | 24-08-2007 |
| | | RU 2007118155 A | 27-11-2008 |
| | | US 2009199763 A1 | 13-08-2009 |
| | | WO 2006040359 A1 | 20-04-2006 |
| US 2011171462 A1 | 14-07-2011 | CN 102131964 A | 20-07-2011 |
| | | EP 2383373 A1 | 02-11-2011 |
| | | JP 5418236 B2 | 19-02-2014 |
| | | JP 2010189254 A | 02-09-2010 |
| | | KR 20110122090 A | 09-11-2011 |
| | | US 2011171462 A1 | 14-07-2011 |
| | | WO 2010084863 A1 | 29-07-2010 |

EPO FORM P0459

For more details about this annex : see Official Journal of the European Patent Office, No. 12/82

## ANNEX TO THE EUROPEAN SEARCH REPORT ON EUROPEAN PATENT APPLICATION NO. EP 14 15 9915

This annex lists the patent family members relating to the patent documents cited in the above-mentioned European search report. The members are as contained in the European Patent Office EDP file on
The European Patent Office is in no way liable for these particulars which are merely given for the purpose of information.

02-07-2014

| Patent document cited in search report | Publication date | Patent family member(s) | Publication date |
|---|---|---|---|
| EP 2314738 A1 | 27-04-2011 | CN 102084039 A | 01-06-2011 |
| | | EP 2314738 A1 | 27-04-2011 |
| | | KR 20110040814 A | 20-04-2011 |
| | | TW 201009140 A | 01-03-2010 |
| | | US 2011104438 A1 | 05-05-2011 |
| | | WO 2010001804 A1 | 07-01-2010 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 4808551 A, Mori
- US 20080083970 A